# EUROPEAN PATENT SPECIFICATION

(11) **EP 4 020 945 B1**
(45) Date of publication and mention of the grant of the patent: **01.10.2025**
(21) Application number: 20862635.8
(22) Date of filing: 23.07.2020
(51) Int. Cl.: H04M 1/02, H04M 1/03, H04R 7/04, H04M 1/60

(54) **DISPLAY TERMINAL**
ANZEIGETERMINAL
TERMINAL D'AFFICHAGE

(30) Priority: 12.09.2019 CN 201910866768
(43) Date of publication of application: 29.06.2022
(73) Proprietor: Huawei Technologies Co., Ltd., Longgang District Shenzhen, Guangdong 518129 (CN)
(72) Inventor: LI, Yingming, Shenzhen, Guangdong 518129 (CN); CHEN, Senjun, Shenzhen, Guangdong 518129 (CN); YEH, Chien Feng, Shenzhen, Guangdong 518129 (CN); QIN, Renxuan, Shenzhen, Guangdong 518129 (CN); XU, Chao, Shenzhen, Guangdong 518129 (CN); TU, Haisheng, Shenzhen, Guangdong 518129 (CN)
(74) Representative: Isarpatent
(86) International application number: PCT/CN2020/103865
(87) International publication number: WO 2021/047300

(56) References cited:
- WO-A2-97/09842
- CN-A- 106 126 181
- CN-A- 110 018 809
- CN-A- 110 049 412
- CN-A- 110 049 416
- CN-A- 110 087 172
- US-A1- 2015 010 173
- US-A1- 2015 146 892
- US-A1- 2019 037 164
- US-A1- 2019 050 024
- US-A1- 2019 155 087
- US-A1- 2019 208 299

## Description

### TECHNICAL FIELD

This application relates to the field of display technologies, and in particular, to a display terminal.

### BACKGROUND

A user makes an increasingly high requirement on an overall screen-to-body ratio of a display terminal. Currently, the display terminal, for example, a top of a front, needs to be punctured to mount a receiver. In this way, a display cannot completely occupy the front of the display terminal due to presence of the receiver. Consequently, the overall screen-to-body ratio decreases, and this is unfavorable to non-porous design of the display terminal.

US 2019/0208299 A1 discloses a display apparatus which includes a display panel configured to display an image by emitting light, and a sound generation device including a vibration generation module configured to vibrate the display panel.

### SUMMARY

This application provides a display terminal, as defined in the appended set of claims, to resolve a problem that an overall screen-to-body ratio decreases due to a receiver disposed on a display terminal.

According to the invention as defined in claim 1, a display terminal is provided. The display terminal includes a middle frame, a display module, a vibrator, and at least one vibrating sheet. The display module is connected to the middle frame, and accommodation space is formed between the display module and the middle frame. At least a part of the vibrator is disposed in the accommodation space. The vibrator is connected to the display module or the middle frame. The vibrating sheet is located in the accommodation space. An upper surface of the vibrating sheet is connected to a lower surface of the display module. A lower surface of the vibrating sheet faces the middle frame. In a direction perpendicular to the upper surface of the vibrating sheet, the vibrator and the vibrating sheet are configured to drive the display module to vibrate up and down. In this way, the vibrating sheet and the vibrator may have a same vibration phase, and therefore vibration of the vibrating sheet and the vibrator can be superimposed and then coupled to the display module, to increase, in a vibration process, amplitude of the display module that serves as a diaphragm and increase volume of a high-frequency sound emitted by the display terminal.

The display further comprises at least one first mass block and is characterized in that the vibrating sheet is located between the vibrator and the display module, the lower surface of the vibrating sheet is connected to an upper surface of the vibrator, and a lower surface of the vibrator is connected to the middle frame, wherein the area of the upper surface of the vibrating sheet is greater than an area of the upper surface of the vibrator, wherein the first mass block is disposed on the lower surface of the vibrating sheet; and a region in which the vibrator is vertically projected on the lower surface of the vibrating sheet and a region in which the first mass block is vertically projected on the lower surface of the vibrating sheet do not overlap.

Optionally, the display terminal further includes a first support sheet. The first support sheet is located between the vibrating sheet and the display module. An upper surface of the first support sheet is connected to the lower surface of the display module, and a lower surface of the first support sheet is connected to the upper surface of the vibrating sheet. An area of the upper surface of the first support sheet is greater than an area of the upper surface of the vibrating sheet. In this way, there is a relatively large contact area between the first support sheet and the display module because the first support sheet is of a sheet-like structure. Therefore, by setting the upper surface and the lower surface of the first support sheet to be respectively in contact with the display module and the vibrating sheet, a contact area between the vibrating sheet and the display module may be increased, so that driving force provided by the vibrating sheet and the vibrator for the display module in a vibration process can be more evenly applied to the display module, to reduce a probability that the display module is damaged in the vibration process. In addition, by using the first support sheet, an area of a deformation region of the display module may be further increased, so that the driving force provided by the vibrating sheet and the vibrator for the display module in the vibration process can be transferred to the display module to a greater extent, to improve efficiency of driving, by the vibrating sheet and the vibrator, the display module to vibrate, reduce power consumption, and improve an effect for implementing sound on display.

According to the claimed invention, the vibrating sheet is located between the vibrator and the display module, the lower surface of the vibrating sheet is connected to an upper surface of the vibrator, and a lower surface of the vibrator is connected to the middle frame. In this way, in a process of vibrating up and down by the vibrator, driving force may be directly transferred to the vibrating sheet, and is applied to the display module after being superimposed with the vibration of the vibrating sheet.

According to the claimed invention, the area of the upper surface of the vibrating sheet is greater than an area of the upper surface of the vibrator. In this way, there is a relatively large contact area between the upper surface of the vibrating sheet and the display module because the vibrating sheet is of a sheet-like structure. Therefore, by setting the upper surface and the lower surface of the vibrating sheet to be respectively in contact with the display module and the vibrator, a contact area between the vibrator and the display module may be increased, so that driving force provided by the vibrator for the display module in a vibration process can be more evenly applied to the display module, to reduce a probability that the display module is damaged in the vibration process. In addition, by increasing the area of the upper surface of the vibrating sheet, the area of the deformation region of the display module may be further increased, so that the driving force provided by the vibrator for the display module in the vibration process can be transferred to the display module to a greater extent, to improve efficiency of driving, by the vibrator, the display module to vibrate, reduce power consumption, and improve an effect for implementing sound on display.

According to the claimed invention, the display terminal further includes at least one first mass block. The first mass block is disposed on the lower surface of the vibrating sheet. A region in which the vibrator is vertically projected on the lower surface of the vibrating sheet and a region in which the first mass block is vertically projected on the lower surface of the vibrating sheet do not overlap. In a deformation process of the vibrating sheet, the first mass block may generate a vibration acceleration, and the acceleration is coupled to the display module by using the vibrating sheet, so that driving force coupled to the display module by using the vibrating sheet can be increased, to increase volume for implementing sound on display.

Optionally, an upper surface of the vibrator is connected to the lower surface of the display module, a lower surface of the vibrator is connected to the middle frame, and a region in which the vibrator is vertically projected on the lower surface of the display module and a region in which the vibrating sheet is vertically projected on the lower surface of the display module do not overlap. In this way, by disposing the vibrating sheet around the vibrator, a gap between the display module and the middle frame may be reduced, to reduce a thickness of the display terminal.

Optionally, the display terminal further includes a second support sheet. The second support sheet is located between the vibrator and the display module, an upper surface of the second support sheet is connected to the lower surface of the display module, and a lower surface of the second support sheet is connected to the upper surface of the vibrator. An area of the upper surface of the second support sheet is greater than an area of the upper surface of the vibrator. In this way, there is a relatively large contact area between the second support sheet and the display module because the second support sheet is of a sheet-like structure. Therefore, by setting the upper surface and the lower surface of the second support sheet to be respectively in contact with the display module and the vibrator, a contact area between the vibrator and the display module may be increased, so that driving force provided by the vibrator for the display module in a vibration process can be more evenly applied to the display module, to reduce a probability that the display module is damaged in the vibration process. In addition, by using the second support sheet, the area of the deformation region of the display module may be further increased, so that the driving force provided by the vibrator for the display module in the vibration process can be transferred to the display module to a greater extent, to improve efficiency of driving, by the vibrator, the display module to vibrate, reduce power consumption, and improve an effect for implementing sound on display.

Optionally, the display terminal further includes at least one second mass block. The second mass block is disposed on the lower surface of the second support sheet. A region in which the vibrator is vertically projected on the lower surface of the second support sheet and a region in which the second mass block is vertically projected on the lower surface of the second support sheet do not overlap. A manner of disposing the second mass block and technical effects are the same as a manner of disposing the first mass block. Details are not described herein.

Optionally, the display terminal further includes at least one third mass block. The third mass block is located on the lower surface of the vibrating sheet. A manner of disposing the third mass block and technical effects are the same as the manner of disposing the first mass block. Details are not described herein.

Optionally, the display terminal further includes a first glue layer located on the upper surface of the vibrating sheet. The first glue layer is disposed along an edge of the upper surface of the vibrating sheet. Therefore, a shape and arrangement of the first glue layer can be set based on a deformation form and a deformation degree of the vibrating sheet, so that a manner of disposing the first glue layer is more favorable to drive the display module to vibrate.

Optionally, a thickness of the vibrating sheet ranges from 0.2 mm to 2 mm. When the thickness of the vibrating sheet ranges from 0.2 mm to 2 mm, it may be ensured that the vibrating sheet has a specific driving capability when the vibrating sheet is prone to vibrate, and impact of the thickness of the vibrating sheet on an overall thickness of the display terminal may be alleviated.

Optionally, an adhesive layer is disposed between the display module and the middle frame. A thickness of the adhesive layer ranges from 0.2 mm to 0.5 mm. In this way, the adhesive layer can firmly bond the display module and the middle frame. In addition, in the thickness range, a larger thickness of the adhesive layer indicates a softer texture of the adhesive layer and a higher probability that the display module vibrates after force is applied. This is favorable to increase volume for implementing sound on display. In addition, a Young's modulus of the adhesive layer may range from 10 Mpa to 80 Mpa. In this case, a smaller Young's modulus of the adhesive layer indicates a softer boundary condition of the display terminal and a higher probability that the display module vibrates. In this way, the volume for implementing sound on display can be effectively increased.

Optionally, the vibrator includes a first magnetic object and a second magnetic object. The first magnetic object is connected to the display module, and the second magnetic object is connected to the middle frame. The first magnetic object is connected to a surface that is of the display module and that faces the middle frame, and the second magnetic object may pass through a mounting hole, and be fastened to a second surface of the middle frame by using a bracket. In this case, a part of the second magnetic object may be located in the mounting hole, and therefore space occupied by the vibrator in the accommodation space may be reduced, to reduce a gap between the display module and the middle frame, so as to reduce a thickness of the display terminal.

Optionally, the display terminal includes an audio digital processor, a first power amplifier, and a filter. An output end of the audio digital processor is coupled to an input end of the first power amplifier. The audio digital processor is configured to output an audio signal to the first power amplifier. A first output end of the first power amplifier is coupled to the filter, and a second output end of the first power amplifier is coupled to the vibrator. The first power amplifier is configured to amplify the audio signal, so that a vibration phase of the vibrator is a first phase. An output end of the filter is connected to the vibrating sheet, and the filter is configured to filter the audio signal, so that a vibration phase of the vibrating sheet is the first phase. When a CPU outputs a low-frequency signal, after the low-frequency signal passes through the audio digital processor and the first power amplifier, an audio signal that is at hundreds of kHz and output by the first power amplifier is applied to the vibrator, to drive the vibrator to vibrate. The vibrator that serves as an inductor filters out a part of the audio signal at hundreds of kHz, and vibrates under action of the remaining low-frequency signal. In addition, after the audio signal that is at hundreds of kHz and output by the first power amplifier passes through the filter, a part of the audio signal at hundreds of kHz is filtered out, and the remaining low-frequency signal is applied to the vibrating sheet. The vibrator and the vibrating sheet are connected in parallel, and therefore a same voltage is applied to the vibrator and the vibrating sheet. On this basis, under driving of the low-frequency signal, there is relatively small impedance for a coil in the vibrator, and therefore a relatively strong current flows through the coil. There is relatively large impedance for the vibrating sheet that serves as a capacitor, and therefore a relatively weak current flows through the vibrating sheet. In this case, when the vibrator and the vibrating sheet simultaneously vibrate, vibration of the vibrator and the vibrating sheet may be superimposed because the vibration phases are the same, and the vibrator serves as a main driving source to drive the display module to vibrate, to emit a low-frequency signal. Alternatively, when a CPU outputs a high-frequency signal, there is relatively large impedance for a coil in the vibrator, and therefore a relatively weak current flows through the coil. There is relatively small impedance for the vibrating sheet that serves as a capacitor, and therefore a relatively strong current flows through the vibrating sheet. In this case, when the vibrator and the vibrating sheet simultaneously vibrate, vibration of the vibrator and the vibrating may be superimposed, and the vibrating sheet may serve as a main driving source to drive the display module to vibrate, to emit a high-frequency signal, so as to resolve a problem that a high-frequency signal is emitted on a display at relatively low volume.

Optionally, the display terminal includes an audio digital processor, a first power amplifier, and a second power amplifier. An output frequency of the first power amplifier is greater than an output frequency of the second power amplifier. An output end of the audio digital processor is coupled to an input end of the first power amplifier and the second power amplifier. The audio digital processor is configured to output an audio signal to the first power amplifier and the second power amplifier. An output end of the first power amplifier is coupled to the vibrator. The first power amplifier is configured to amplify the audio signal, so that a vibration phase of the vibrator is a first phase. An output end of the second power amplifier is coupled to the vibrating sheet, and the second power amplifier is configured to amplify the audio signal, so that a vibration phase of the vibrating sheet is the first phase. The vibrator vibrates under driving of the first power amplifier, and when driving a display to emit a low-frequency signal, serves as a main driving source to drive the display module to vibrate. The vibrating sheet vibrates under driving of the second power amplifier, and when driving the display to emit a high-frequency signal, serves as a main driving source to drive the display module to vibrate.

### BRIEF DESCRIPTION OF DRAWINGS

FIG. 1 is a schematic diagram of a structure of a display terminal according to an embodiment of this application;
FIG. 2 is a schematic diagram of a structure of a display module shown in FIG. 1;
FIG. 3 is another schematic diagram of a structure of a display module shown in FIG. 1;
FIG. 4a is a schematic diagram of a structure of connection between a display module and a middle frame according to an embodiment of this application;
FIG. 4b is a schematic diagram of a structure of connection between a display module, a middle frame, and a housing according to an embodiment of this application;
FIG. 5a is a schematic diagram of a structure of another display terminal according to an embodiment of this application;
FIG. 5b is a schematic diagram of a specific structure of a vibrator in FIG. 5a;
FIG. 6a is a schematic diagram of a structure of another display terminal according to an embodiment of this application;
FIG. 6b is a schematic diagram of a structure of a first glue layer in FIG. 6a;
FIG. 6c is a schematic diagram of another structure of a first glue layer in FIG. 6a;
FIG. 6d is a schematic diagram of another structure of a first glue layer in FIG. 6a;
FIG. 6e is a schematic diagram of another structure of a first glue layer in FIG. 6a;
FIG. 7a is a schematic diagram of a structure of another display terminal according to an embodiment of this application;
FIG. 7b is a schematic diagram of a manner of disposing a first mass block in FIG. 7a;
FIG. 7c is a schematic diagram of another manner of disposing a first mass block in FIG. 7a;
FIG. 7d is a schematic diagram of another manner of disposing a first mass block in FIG. 7a;
FIG. 8a is a schematic diagram of a structure of another display terminal according to an embodiment of this application;
FIG. 8b is a schematic diagram of a structure of another display terminal according to an embodiment of this application;
FIG. 9a is a schematic diagram of a structure of another display terminal according to an embodiment outside the scope of the invention as claimed;
FIG. 9b is a schematic diagram of a structure of a vibrating sheet in FIG. 9a;
FIG. 9c is a schematic diagram of another structure of a vibrating sheet in FIG. 9a;
FIG. 9d is a schematic diagram of a structure of another display terminal according to an embodiment outside the scope of the invention as claimed;
FIG. 9e is a schematic diagram of a structure of another display terminal according to an embodiment outside the scope of the invention as claimed;
FIG. 9f is a schematic diagram of a manner of disposing a third mass block in FIG. 9e;
FIG. 10 is a schematic diagram of a structure of a circuit configured to drive a vibrator and a vibrating sheet to vibrate according to an embodiment of this application;
FIG. 11a is a schematic diagram of a structure of another circuit configured to drive a vibrator and a vibrating sheet to vibrate according to an embodiment of this application;
FIG. 11b is a schematic diagram of a structure of another circuit configured to drive a vibrator and a vibrating sheet to vibrate according to an embodiment of this application;
FIG. 11c is a schematic diagram of a structure of another circuit configured to drive a vibrator and a vibrating sheet to vibrate according to an embodiment of this application; and
FIG. 11d is a schematic diagram of a structure of another circuit configured to drive a vibrator and a vibrating sheet to vibrate according to an embodiment of this application.

### Reference numerals:

01: Display terminal; 10: Display module; 11: Middle frame; 112: Bearing part; 113: Frame; 300: Audio digital processor; 12: Housing; 101: Display; 102: BLU; 103: Cover; 110: Bearing platform; 111: Adhesive layer; 20: Accommodation space; 31: Vibrator; 32: Vibrating sheet; 122: Mounting hole; 123: Bracket; 311: First magnetic object; 312: Second magnetic object; 321a: First glue layer; 321b: Second glue layer; 321c: Third glue layer; 321d: Fourth glue layer; 321e: Fifth glue layer; 322: First mass block; 323: First support sheet; 324: Second support sheet; 325: Second mass block; 326: Third mass block; 41: Audio signal receiving module; 41: Sound effect operation module; 301: First power amplifier; 302: Filter; 303: Second power amplifier; 304: Third power amplifier; and 33: Moving coil speaker.

### DESCRIPTION OF EMBODIMENTS

The following describes the technical solutions in the embodiments of this application with reference to the accompanying drawings in the embodiments of this application. It is clearly that the described embodiments are merely a part rather than all of the embodiments of this application.

The following terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this application, orientation terms such as "upper", "lower", "left", and "right" may be defined by, but are not limited to, orientations of components schematically placed in the accompanying drawings. It should be understood that these orientation terms may be relative concepts, and are used for description and clarification of "relative", and may change correspondingly according to a change in a placement orientation of a component drawing in the drawings.

In this application, unless otherwise expressly specified and limited, the term "connection" should be understood in a broad sense. For example, "connection" may be a fixed connection, a detachable connection or an integral connection; and may be a direct connection or an indirect connection by using an intermediate medium. In addition, the term "coupled" may be a manner of implementing an electrical connection for signal transmission.

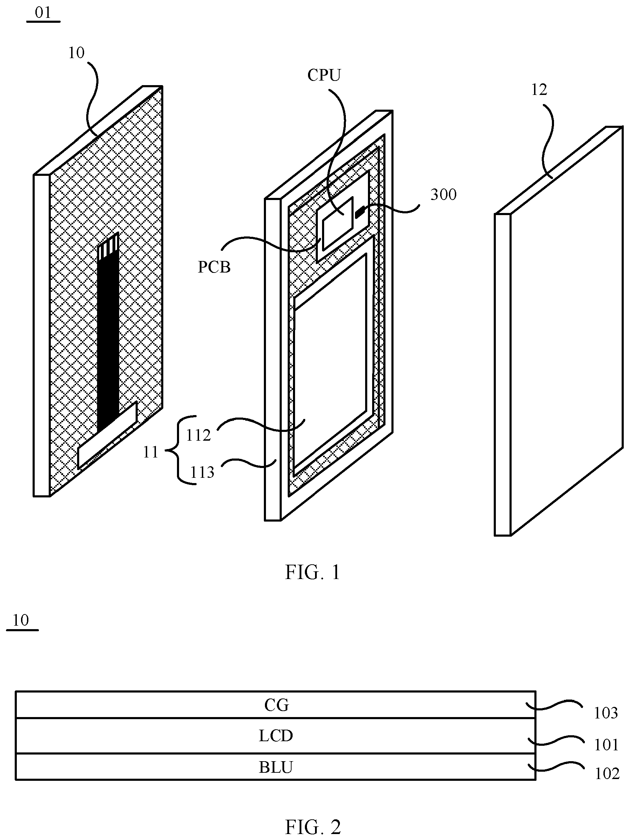

The embodiments of this application provide a display terminal. The display terminal includes, for example, a mobile phone, a tablet computer, a personal digital assistant (personal digital assistant, PDA), or a vehicle-mounted computer. A specific form of the display terminal is not specially limited in the embodiments of this application. For ease of description, the following provides description by using an example in which the display terminal is a mobile phone shown in FIG. 1.

As shown in FIG. 1, the display terminal 01 mainly includes but is not limited to a display module 10. As shown in FIG. 2, the display module 10 includes a display panel (display panel, DP) 101.

In some embodiments of this application, the display panel 101 may be a liquid crystal display (liquid crystal display, LCD). In this case, the display module 10 further includes a back light unit (back light unit, BLU) 102 configured to provide a light source for the LCD.

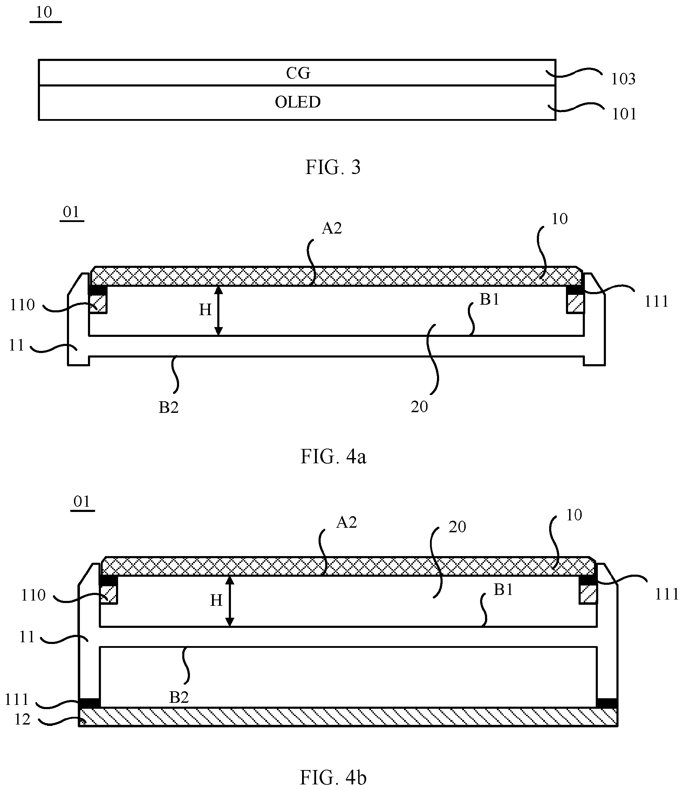

Alternatively, in some other embodiments of this application, as shown in FIG. 3, the display panel 101 is an organic light emitting diode (organic light emitting diode, OLED) display, and the OLED display can implement self-luminescence. Therefore, no BLU is disposed in the display module 10.

It should be noted that a substrate in the OLED display may be made of a flexible resin material. In this case, the OLED display is a flexible display, and therefore the mobile phone that includes the OLED display may be a foldable mobile phone.

Alternatively, the substrate in the OLED display may be made of a hard-textured material, such as glass. In this case, the OLED display is a hard display.

In some embodiments of this application, as shown in FIG. 2 or FIG. 3, the display module 10 further includes a cover 103 located on a display side of the display panel 101, for example, a cover glass (cover glass, CG). The cover glass has specific toughness.

In addition, the display terminal 01 further includes a middle frame 11 shown in FIG. 1. The display module 10 is mounted on the middle frame 11. In some embodiments of this application, as shown in FIG. 4a, a bearing platform 110 is disposed on a side that is of the middle frame 11 and close to the display module 10. An adhesive layer 111 is attached to the bearing platform 110. The display module 10 is fastened to the middle frame 11 by using the adhesive layer 111, so that the display module 10 is connected to the middle frame 11, to mount the display module 10 on the middle frame 11.

For example, the adhesive layer 111 may be foam adhesive. The foam adhesive has specific elasticity and can be deformed under action of external force.

In addition, the display terminal 01 further includes the middle frame 11 shown in FIG. 1. Internal elements such as a battery, a printed circuit board (printed circuit board, PCB), a camera (Camera), and an antenna are mounted on a surface (a second surface B2 in FIG. 4a) that is of the middle frame 11 and away from the display module 10. As shown in FIG. 1, a central processing unit (Central Processing Unit, CPU) may be disposed on the PCB.

In this case, the display terminal 01 may further include a housing 12 shown in FIG. 1. As shown in FIG. 4b, the housing 12 is disposed on a side on which the second surface B2 of the middle frame 11 is located, and may be connected to the middle frame 11 by using the adhesive layer 111. The housing 12 can protect the internal elements mounted on the middle frame 11.

In addition, as shown in FIG. 4a, there is a gap H between a lower surface A2 (namely, a surface that is of the display module 10 and that faces the middle frame 11) of the display module 10 fastened to the bearing platform 110 and a first surface B1 of the middle frame 11. Accommodation space 20 is formed between the display module 10 and the middle frame 11 based on the gap H.

It should be noted that as shown in FIG. 1, the middle frame 11 includes a bearing part 112 configured to carry the battery and the PCB and a frame 113 disposed around the bearing part 112. The bearing part 112 is parallel or approximately parallel to the display module 10. In this case, in the embodiments of this application, facing the middle frame 11 may mean facing the bearing part 112 of the middle frame 11.

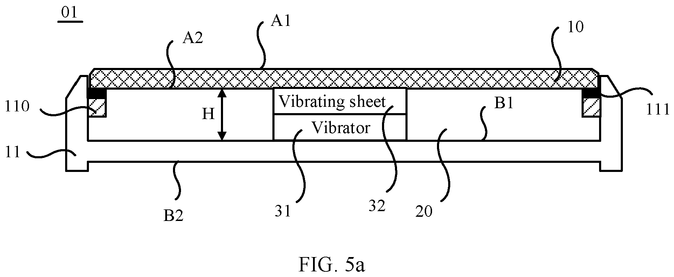

On this basis, the display terminal 01 further includes a vibrator 31 shown in FIG. 5a. At least a part of the vibrator 31 is disposed in the accommodation space 20. The vibrator 31 is connected to the display module 10 or the middle frame 11. The vibrator 31 is configured to drive, in a direction perpendicular to an upper surface A1 (namely, a display surface of the display module 10) (shown in FIG. 5a) of the display module 10 based on a driving signal output by an audio (audio) digital processor (digital signal processing, DSP) 300 shown in FIG. 1, the display module 10 to vibrate. In this way, driven by the vibrator 31, the display module 10 that serves as a diaphragm drives, in a vibration process, air to generate a sound, to implement sound on display.

It should be noted that, at least a part of the vibrator 31 being disposed in the accommodation space 20 means that in some embodiments of this application, the entire vibrator 31 may be disposed in the accommodation space 20. For example, the vibrator 31 may be a linear vibrator.

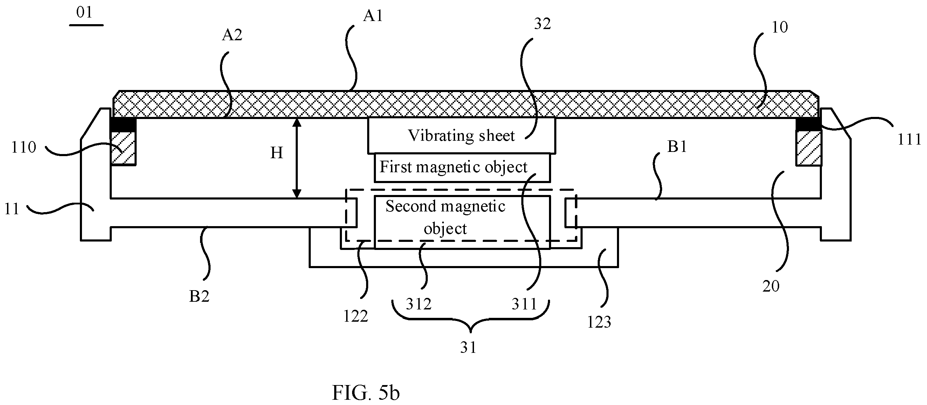

Alternatively, at least a part of the vibrator 31 being disposed in the accommodation space 20 means that as shown in FIG. 5b, a mounting hole 122 may be disposed on the middle frame 11, and a part of the vibrator 31 passes through the mounting hole 122, and is connected to the second surface B2 of the middle frame 11.

For example, the vibrator 31 may include a first magnetic object 311 and a second magnetic object 312 that move relatively in a working state. The first magnetic object 311 is connected to the surface that is of the display module 10 and that faces the middle frame 11, and the second magnetic object 312 may pass through the mounting hole 122, and be fastened to the second surface B2 of the middle frame by using a bracket 123.

In this case, a part of the second magnetic object 312 may be located in the mounting hole 122, and therefore space occupied by the vibrator 31 in the accommodation space 20 may be reduced, to reduce the gap H between the display module 10 and the middle frame 11, so as to reduce a thickness of the display terminal 01.

The first magnetic object 311 may be a coil, and the second magnetic object 312 may be a magnet. Alternatively, the first magnetic object 311 is a magnet, and the second magnetic object 312 is a coil. In this case, after receiving the driving signal output by the audio digital processor 300, the coil generates an alternating magnetic field. Intensity of the magnetic field is directly proportional to intensity of a current in the coil. The magnet can generate a constant magnetic field of constant intensity and in a constant direction. With interaction of the two magnetic fields, the coil may cut a magnetic induction line in the direction perpendicular to the lower surface A1 (shown in FIG. 5a) of the display module 10, and vibrate up and down, to drive the display module 10 to vibrate.

A higher frequency of a sound signal for implementing sound on display indicates larger inductance of the coil. In this case, even if the audio digital processor 300 outputs a maximum voltage, the current in the coil is reduced due to an increase in impedance of the coil. It may be learned from the foregoing description that the intensity of the magnetic field generated by the coil is directly proportional to the intensity of the current in the coil, and therefore the intensity of the magnetic field generated by the coil is also reduced. Therefore, in a process of implementing sound on display, there is small power for a high-frequency sound, and consequently the display terminal 01 emits the high-frequency sound at low volume.

To increase the volume of the high-frequency sound, the display terminal 01 further includes at least one vibrating sheet 32 shown in FIG. 5a. The vibrating sheet 32 is located in the accommodation space 20. An upper surface (namely, a surface that is of the vibrating sheet 32 and that faces the display module 10) of the vibrating sheet 32 is connected to the lower surface A2 of the display module 10, and a lower surface (which is disposed opposite to the upper surface of the vibrating sheet 32) of the vibrating sheet 32 faces the middle frame 11.

The vibrating sheet 32 is configured to: after receiving the driving signal output by the audio digital processor 300, drive, in a direction perpendicular to the upper surface of the vibrating sheet 32 (or the upper surface A1 of the display module 10), the display module 10 to vibrate up and down. In this way, the vibrating sheet 32 and the vibrator 31 may have a same vibration phase, and therefore vibration of the vibrating sheet 32 and the vibrator 31 can be superimposed and then coupled to the display module 10, to increase, in a vibration process, amplitude of the display module 10 that serves as a diaphragm and increase the volume of the high-frequency sound emitted by the display terminal 01.

On this basis, the vibrating sheet 32, the display module 10, and the first magnetic object 311 in the vibrator 31 may form a sound emitting system of the display terminal 01. In the sound emitting system, the display module 10 serves as the diaphragm, vibrates under joint driving of the vibrator 31 and the vibrating sheet 32, and drives, in the vibration process, air to emit a sound, to implement sound on display. In this case, the sound system can implement a function of a receiver or a speaker, to play an audio signal.

It can be learned from the foregoing description that the display panel 101 in the display module 10 may be an LCD or an OLED display. In addition, compared with the LCD, the OLED display can self-illuminate. Therefore, no BLU is disposed in the display module 10, and the display module 10 is thin. When the display module 10 serves as the diaphragm to implement the sound on display, deformation is more likely to occur, so that a sound effect of the diaphragm is better.

Structures and disposing manners of the vibrator 31 and the vibrating sheet 32 are described below.

### Embodiment 1

In this embodiment, as shown in FIG. 5a, the vibrator 31 and the vibrating sheet 32 may be disposed in a stack manner. In this case, the vibrating sheet 32 is located between the vibrator 31 and the display module 10. The lower surface (namely, a surface that is of the vibrating sheet 32 and that faces the middle frame 11) of the vibrating sheet 32 is connected to an upper surface (namely, a surface that is of the vibrator 31 and that faces the display module 10) of the vibrator 31. In addition, the upper surface of the vibrating sheet 32 is connected to the lower surface A2 of the display module 10. The vibrator 31 may be connected to the display module 10 by using the vibrating sheet 32.

In this case, in a vibration process, the vibrator 31 may be superimposed with vibration of the vibrating sheet 32 and coupled to the display module 10, to increase vibration amplitude of the display module 10, so as to increase volume for implementing sound on display.

In some embodiments of this application, the vibrating sheet 32 may include a layer of electrostrictive sheets or a plurality of electrostrictive sheets disposed in a stack manner. Each electrostrictive sheet includes an upper electrode layer and a lower electrode layer made of a metal material, and an electrostrictive dielectric layer, for example, a piezoelectric ceramic dielectric layer, located between the upper electrode layer and the lower electrode layer.

On this basis, after a voltage is applied to the upper electrode layer and the lower electrode layer, the electrostrictive dielectric layer may be elastically deformed under action of electric fields generated at the upper electrode layer and the lower electrode layer. In this way, in a deformation process, the electrostrictive dielectric layer drives the display module 10 to vibrate in the direction perpendicular to the upper surface A1 (shown in FIG. 5a) of the display module 10. In this case, a deformation form of the electrostrictive dielectric layer may be controlled by controlling parameters such as intensity and a direction of the electric field, to control a vibration frequency of the display module 10.

Alternatively, in some other embodiments, the vibrating sheet 32 may include a magnetostrictive material layer. On this basis, a conductive coil may be disposed outside the magnetostrictive material layer. The magnetostrictive material layer may be elastically deformed under action of an applied magnetic field generated after the conductive coil is powered on. In this way, in a deformation process, the magnetostrictive material layer drives the display module 10 to vibrate in a direction perpendicular to the lower surface A2 (shown in FIG. 5a) of the display module 10.

For ease of description, the following provides description by using an example in which the vibrating sheet 32 includes at least one piezoelectric ceramic layer.

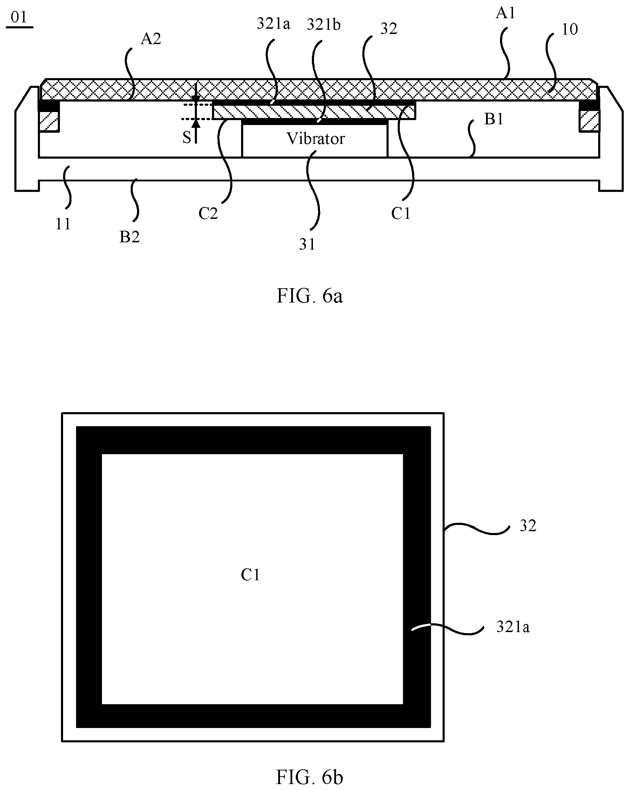

In a possible implementation of this embodiment, as shown in FIG. 6a, the display terminal 01 includes a first glue layer 321a located on the upper surface C1 of the vibrating sheet 32. The vibrating sheet 32 is connected to the lower surface A2 of the display module 10 by using the first glue layer 321a.

For example, the first glue layer 321a may be an entire film layer with adhesive performance that covers the entire upper surface C1 of the vibrating sheet 32.

Alternatively, the first glue layer 321a may have a specific glue layer pattern. For example, as shown in FIG. 6b, the glue layer pattern of the first glue layer 321a is disposed around an edge of the upper surface C1 of the vibrating sheet 32. For example, the first glue layer 321a may be disposed around the edge of the upper surface C1 of the vibrating sheet 32, to form a head-to-tail connected film layer of a frame structure.

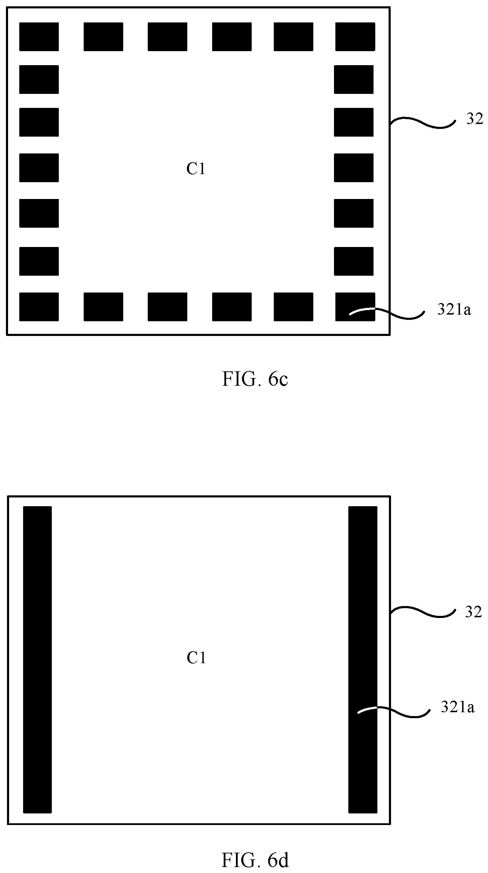

Alternatively, for another example, as shown in FIG. 6c, the glue layer pattern of the first glue layer 321a is a plurality of block-shaped film layers disposed around the edge of the upper surface C1 of the vibrating sheet 32.

Alternatively, for another example, as shown in FIG. 6d, the glue layer pattern of the first glue layer 321a includes two strip-like film layers disposed on a left side (close to the frame 113 on a left side of the middle frame 11) and a right side (close to the frame 113 on a right side of the display terminal 01) of the upper surface C1 of the vibrating sheet 32.

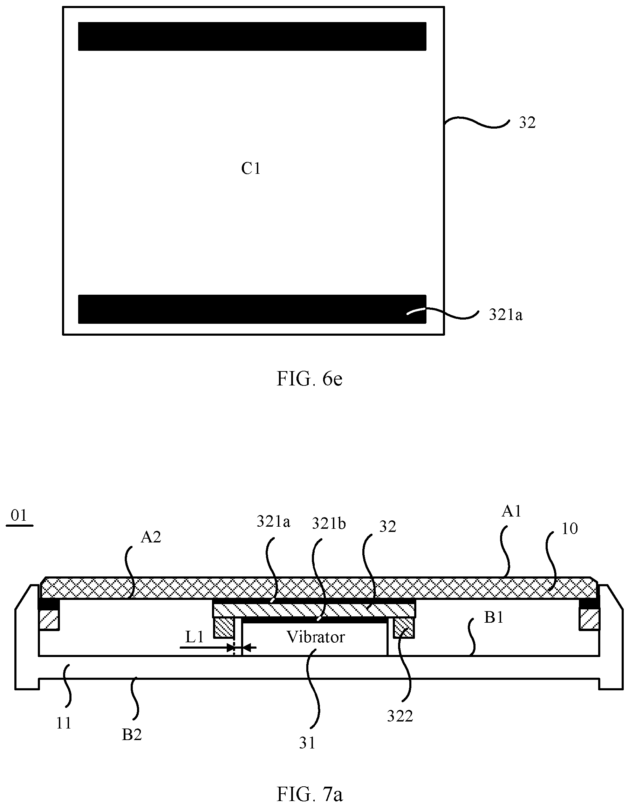

Alternatively, for another example, as shown in FIG. 6e, the glue layer pattern of the first glue layer 321a includes two strip-like film layers disposed on an upper side (close to the frame 113 on an upper side of the display terminal 01) and a lower side (close to the frame 113 on a lower side of the display terminal 01) of the upper surface C1 of the vibrating sheet 32.

It should be noted that a manner of disposing a structure or the pattern of the first glue layer 321a is merely described above by using an example. A person skilled in the art may perform force analysis based on a deformation form and a deformation degree of the vibrating sheet 32 in a process of driving the display module 10 to vibrate, to obtain a disposing manner that is more favorable to drive the display module 10 to vibrate.

Other manners of disposing the structure or the pattern of the first glue layer 321a are not described herein one by one, provided that it can be ensured that in a deformation process, the vibrating sheet 32 drives the display module 10 to vibrate in the direction perpendicular to the upper surface A1 of the display module 10.

In some embodiments of this application, the first glue layer 321a may be glue with relatively high adhesive strength, for example, double-component glue. Alternatively, in some other embodiments of this application, to facilitate removal of the vibrating sheet 32 from the display module 10 during maintenance of the display module 10, the first glue layer 321a may be adhesive (namely, double-sided tape).

In addition, as shown in FIG. 6a, the lower surface C2 of the vibrating sheet 32 is connected to the vibrator 31 by using a second glue layer 321b. The second glue layer 321b is used to transfer vibration of the vibrator 31 to the vibrating sheet 32 while connecting the vibrator 31 to the vibrating sheet 32, and then transfer the vibration to the display module 10 by using the vibrating sheet 32. In this case, the second glue layer 321b may be an entire film layer with adhesive performance that covers an entire surface that is of the vibrator 31 and that faces the vibrating sheet 32.

It should be noted that there is a low probability that the vibrator 31 and the vibrating sheet 32 are maintained. Therefore, to improve bonding reliability of the vibrator 31 and the vibrating sheet 32, the second glue layer 321b may be glue with relatively high adhesive strength.

In addition, as shown in FIG. 6a, an area of the upper surface C1 of the vibrating sheet 32 is greater than an area of the upper surface (namely, a surface on which the vibrator 31 is in contact with the vibrating sheet 32) of the vibrator 31. In this case, one part of the vibrating sheet 32 is connected to the vibrator 31 by using the second glue layer 321b, and the other part extends out of the vibrator 31, and is located around the vibrator 31.

In this way, there is a relatively large contact area between the upper surface C1 of the vibrating sheet 32 and the display module 10 because the vibrating sheet 32 is of a sheet-like structure. Therefore, by setting the upper surface C1 and the lower surface C2 of the vibrating sheet 32 to be respectively in contact with the display module 10 and the vibrator 31, a contact area between the vibrator 31 and the display module 10 may be increased, so that driving force provided by the vibrator 31 for the display module 10 in a vibration process can be more evenly applied to the display module 10, to reduce a probability that the display module 10 is damaged in the vibration process.

In addition, by increasing the area of the upper surface C1 of the vibrating sheet 32, an area of a deformation region of the display module 10 may be further increased, so that the driving force provided by the vibrator 31 for the display module 10 in the vibration process can be transferred to the display module 10 to a greater extent, to improve efficiency of driving, by the vibrator 31, the display module 10 to vibrate, reduce power consumption, and improve an effect for implementing sound on display.

Hardness of the vibrating sheet 32 is related to a thickness S of the vibrating sheet 32. In some embodiments of this application, the thickness S of the vibrating sheet 32 may range from 0.2 mm to 2 mm. When the thickness of the vibrating sheet 32 is less than 0.2 mm, the vibrating sheet 32 features excessively small thickness S and relatively low hardness. After the audio digital processor 300 (shown in FIG. 1) outputs a driving signal, the vibrating sheet 32 provides relatively weak driving force for the display module 10. In addition, the vibrating sheet 32 can withstand a relatively small voltage output by the audio digital processor 300. In this case, the vibrating sheet 32 has a relatively poor driving capability.

Alternatively, when the thickness S of the vibrating sheet 32 is 2 mm, the vibrating sheet 32 features excessively large thickness S and relatively high hardness. This is unfavorable for the vibrating sheet 32 to vibrate under action of a driving signal. In addition, an overall thickness of the display terminal 01 is affected due to the excessively large thickness S of the vibrating sheet 32.

In conclusion, when the thickness S of the vibrating sheet 32 ranges from 0.2 mm to 2 mm, it may be ensured that the vibrating sheet 32 has a specific driving capability when the vibrating sheet 32 is prone to vibrate, and impact of the thickness S of the vibrating sheet 32 on the overall thickness of the display terminal 01 may be alleviated. In some possible implementations of this application, the thickness S of the vibrating sheet 32 may be 0.2 mm, 0.3 mm, 0.5 mm, 0.8 mm, 1 mm, 1.5 mm, 1.8 mm, or 2 mm.

In addition, the hardness of the vibrating sheet 32 is also related to a Young's modulus of the vibrating sheet 32. When the thickness S of the vibrating sheet 32 is increased in the thickness range, to enable the vibrating sheet 32 to be more prone to vibrate, the Young's modulus of the vibrating sheet 32 may be reduced. Alternatively, when the thickness S of the vibrating sheet 32 is reduced in the thickness range, to enable the vibrating sheet 32 to provide sufficient driving force for the display module 10, the Young's modulus of the vibrating sheet 32 may be increased.

On this basis, to increase driving force coupled to the display module 10 by using the vibrating sheet 32, in some embodiments according to the invention as claimed, the display module 10 further includes at least one first mass block 322 that is shown in FIG. 7a and located on the lower surface C2 (shown in FIG. 6a) of the vibrating sheet 32.

A region in which the vibrator 31 is vertically projected on the lower surface C2 of the vibrating sheet 32 and a region in which the first mass block 322 is vertically projected on the lower surface C2 of the vibrating sheet 32 do not overlap. In this case, the first mass block 322 may be located around the vibrator 31, and there is a first gap L1 between the first mass block 322 and the vibrator 31.

A size of the first gap L1 is not limited in this application, provided that it can be ensured that a case in which vibration of the vibrator 31 is affected because in a vibration process of the vibrator 31, the first mass block 322 is in contact with the vibrator 31 is avoided.

A manner of disposing the first mass block 322 on the lower surface C2 is described below by using an example in which the lower surface C2 of the vibrating sheet 32 is a rectangle.

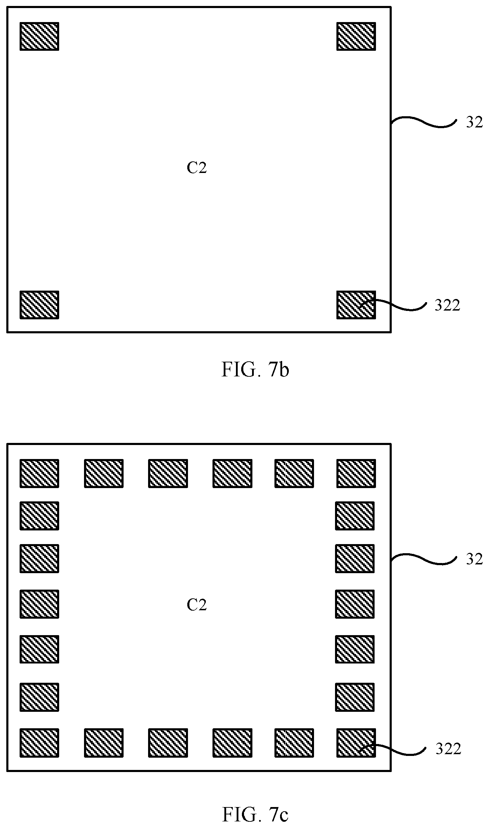

For example, as shown in FIG. 7b, the vibrating sheet 32 may include four first mass blocks 322. Each first mass block 322 is located in one corner of the lower surface C2.

Alternatively, for another example, as shown in FIG. 7c, the vibrating sheet 32 may include a plurality of (for example, at least four) first mass blocks 322. The plurality of first mass blocks 322 are disposed around an edge of the lower surface C2.

It should be noted that when the vibrating sheet 32 includes a plurality of first mass blocks 322, in some embodiments of this application, parameters such as materials, thicknesses, and mass of first mass blocks 322 at different positions may be set based on the deformation form and the deformation degree of the vibrating sheet 32.

For example, when the vibrating sheet 32 vibrates, first mass blocks 322 at different amplitude positions may differ in material, thickness, or mass, and first mass blocks 322 at a same or similar amplitude position may have a same material, a same thickness, or same mass. A person skilled in the art may set the parameters of the plurality of first mass blocks 322 based on the deformation form and the deformation degree of the vibrating sheet 32, and obtain, with reference to force analysis, a disposing manner that is more favorable to drive the display module 10 to vibrate.

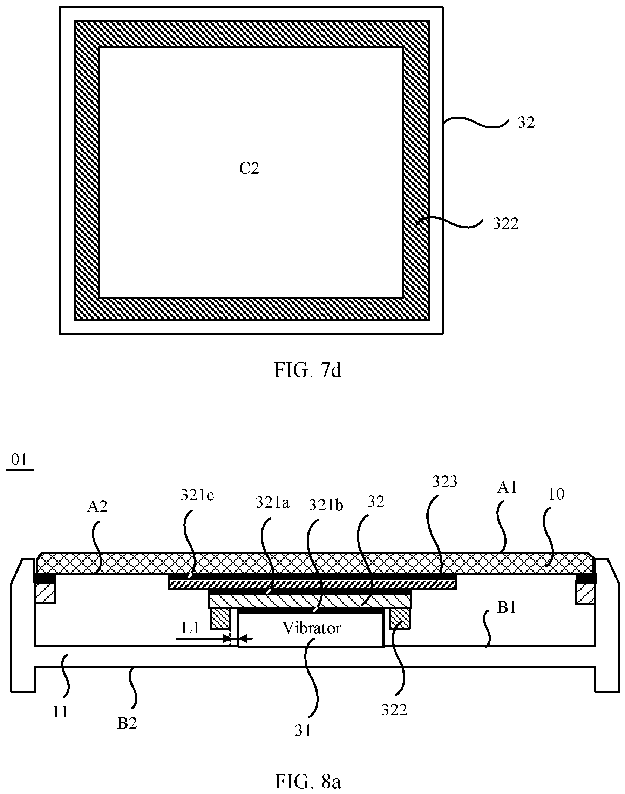

Alternatively, as shown in FIG. 7d, the vibrating sheet 32 may include one first mass block 322. The first mass block 322 is a head-to-tail connected frame structure disposed around the vibrator 31.

In some possible implementations of this application, the first mass block 322 may be made of a metal elemental material or a metal alloy material. In this case, as shown in FIG. 7a, the first mass block 322 is disposed at a part that is of the vibrating sheet 32 and that extends out of the vibrator 31. Therefore, in a deformation process of the vibrating sheet 32, the first mass block 322 may generate a vibration acceleration, and the acceleration is coupled to the display module 10 by using the vibrating sheet 32, so that the driving force coupled to the display module 10 by using the vibrating sheet 32 can be increased, to increase the volume for implementing sound on display.

It should be noted that the manner of disposing the first mass block 322 on the lower surface C2 is merely described above by using an example. A person skilled in the art may perform force analysis based on assistance of the first mass block 322 and the deformation form and the deformation degree of the vibrating sheet 32 in the process of driving the display module 10 to vibrate, to obtain a disposing manner that is more favorable to drive the display module 10 to vibrate.

Other manners of disposing the first mass block 322 on the lower surface C2 are not described herein one by one, provided that it can be ensured that in the deformation process, the vibrating sheet 32 can drive the display module 10 to vibrate in the direction perpendicular to the upper surface A1 of the display module 10.

### Embodiment 2

In this embodiment, a first mass block 322 is disposed on the lower surface C2 of the vibrating sheet 32, which is the same as that in the example 1. The vibrating sheet 32 is located between the vibrator 31 and the display module 10, and the lower surface of the vibrating sheet 32 is connected to an upper surface of the vibrator 31. In addition, the upper surface of the vibrating sheet 32 is connected to the lower surface A2 of the display module 10. A manner of disposing the first mass block 322 is the same as that described above. Details are not described herein.

A difference between this embodiment and the embodiment 1 lies in that the display module 10 further includes a first support sheet 323. The first support sheet 323 is located between the vibrating sheet 32 and the display module 10.

A lower surface (namely, a surface that is of the first support sheet 323 and that faces the middle frame 11) of the first support sheet is connected to the upper surface of the vibrating sheet 32. For example, the lower surface of the first support sheet 323 is connected to the upper surface C1 of the vibrating sheet 32 by using a first glue layer 321a. A manner of disposing the first glue layer 321a is the same as that described above. Details are not described herein.

In addition, an upper surface (namely, a surface that is of the first support sheet 323 and that faces the display module 10) of the first support sheet 323 is connected to the lower surface A2 of the display module 10. For example, the first support sheet 323 may be connected to the lower surface A2 of the display module 10 by using a third glue layer 321c. A manner of disposing the third glue layer 321c may be the same as the manner of disposing the first glue layer 321a. Details are not described herein.

In addition, as shown in FIG. 8a, an area of the upper surface (namely, a surface on which the first support sheet 323 is in contact with the display module 10) of the first support sheet 323 is greater than an area of the upper surface of the vibrating sheet 32.

In this way, there is a relatively large contact area between the first support sheet 323 and the display module 10 because the first support sheet 323 is of a sheet-like structure. Therefore, by setting the upper surface and the lower surface of the first support sheet 323 to be respectively in contact with the display module 10 and the vibrating sheet 32, a contact area between the vibrating sheet 32 and the display module 10 may be increased, so that driving force provided by the vibrating sheet 32 and the vibrator 31 for the display module 10 in a vibration process can be more evenly applied to the display module 10, to reduce a probability that the display module 10 is damaged in the vibration process.

In addition, by using the first support sheet 323, an area of a deformation region of the display module 10 may be further increased, so that the driving force provided by the vibrating sheet 32 and the vibrator 31 for the display module 10 in the vibration process can be transferred to the display module 10 to a greater extent, to improve efficiency of driving, by the vibrating sheet 32 and the vibrator 31, the display module 10 to vibrate, reduce power consumption, and improve an effect for implementing sound on display.

It may be learned from the foregoing description that for the solutions in the embodiment 1 and the embodiment 2, the vibrating sheet 32 in the vibrating sheet 32 is located between the vibrator 31 and the display module 10, and is connected to the vibrator 31 and the display module 10. In this case, a vibration structure that includes the vibrating sheet 32 and the vibrator 31 may be disposed at a central position of the accommodation space 20 (shown in FIG. 4a), in other words, the vibration structure that includes the vibrating sheet 32 and the vibrator 31 is connected to a central position of the display module 10.

In this way, under joint driving of the vibrator 31 and the vibrating sheet 32, driving force may directly act on the central position of the display module 10 that serves as the diaphragm, to increase amplitude of the entire display module 10. Therefore, in a process of implementing sound on display by using the display module 10 that serves as a speaker, both a low-frequency sound signal and a high-frequency sound signal can be transmitted at relatively high volume.

It may be learned from the foregoing description that in comparison with the embodiment 1, in this embodiment, the first support sheet 323 is further disposed between the vibrating sheet 32 and the display module 10. In this case, in some embodiments, to reduce the gap H between the display module 10 and the middle frame 11, a sum of a thickness of the vibrating sheet 32 and a thickness of the first support sheet 323 may range from 0.2 mm to 2 mm. In addition, to increase driving force from the vibrating sheet 32, a Young's modulus of the vibrating sheet 32 may be the same as a Young's modulus of the first support sheet 323.

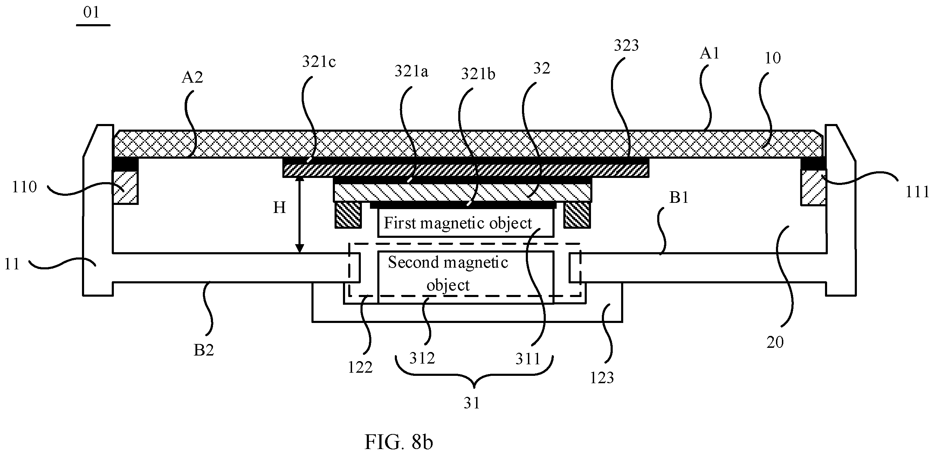

In some other embodiments, the vibrator 31 may include a first magnetic object 311 and a second magnetic object 312 that can move relatively and that are shown in FIG. 8b. In this case, to reduce the gap H between the display module 10 and the middle frame 11, a mounting hole 122 may be disposed on the middle frame 11. The second magnetic object 312 may pass through the mounting hole 122, and be fastened to a second surface B2 of the middle frame by using a bracket 123. A part of the second magnetic object 312 may be located in the mounting hole 122, and therefore space occupied by the vibrator 31 in the accommodation space 20 may be reduced, to reduce the gap H between the display module 10 and the middle frame 11, so as to reduce a thickness of the display terminal 01.

### Example 3

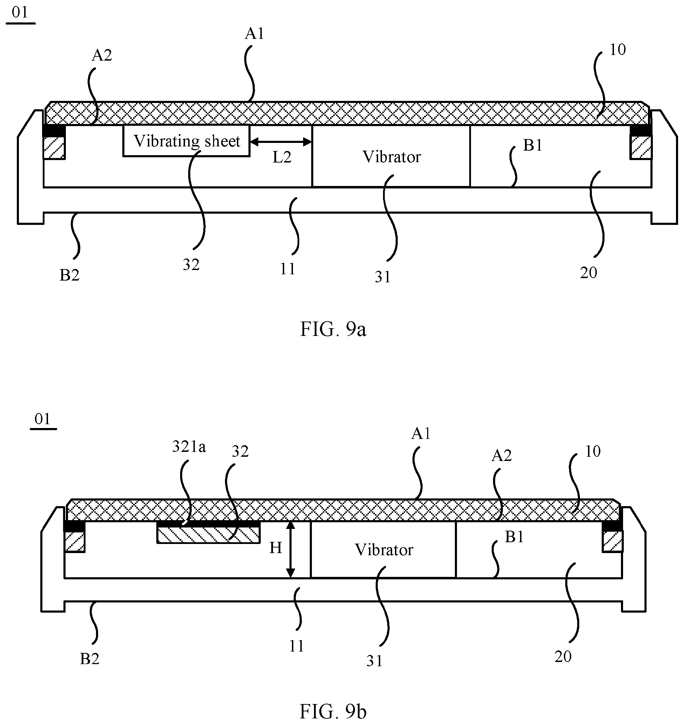

A difference between this example outside the scope of the invention as claimed and the embodiment 1 and the embodiment 2 lies in that as shown in FIG. 9a, an upper surface of the vibrator 31 is connected to the lower surface A2 of the display module 10, and a lower surface of the vibrator 31 is connected to the middle frame 11. In addition, a region in which the vibrator 31 is vertically projected on the lower surface A2 of the display module 10 and a region in which the vibrating sheet 32 is vertically projected on the lower surface A2 of the display module 10 do not overlap.

In this case, the vibrating sheet 32 may be located around the vibrator 31. In addition, there is a second gap L2 between the vibrating sheet 32 and the vibrator 31. A size of the second gap L2 is not limited in the embodiments of this application, provided that it can be ensured that in a vibration process of the vibrating sheet 32 and the vibrator 31, no interference is caused due to vibration of the vibrating sheet 32 and the vibrator 31.

A material of which the vibrating sheet 32 is made is the same as that described above. Details are not described herein. In this example, the vibrating sheet 32 is disposed around the vibrator 31, which is different from the solution according to the claimed invention, in which the vibrating sheet 32 and the vibrator 31 are stacked in the embodiment 1 and the embodiment 2, to reduce the gap H between the display module 10 and the middle frame 11, so as to reduce a thickness of the display terminal 01.

In a possible implementation solution of this example, as shown in FIG. 9b, the vibrating sheet 32 is connected to the lower surface A2 of the display module 10 by using a first glue layer 321a. A manner of disposing a film layer pattern of the first glue layer 321a and a material of which the first glue layer 321a is made are the same as those described above. Details are not described herein.

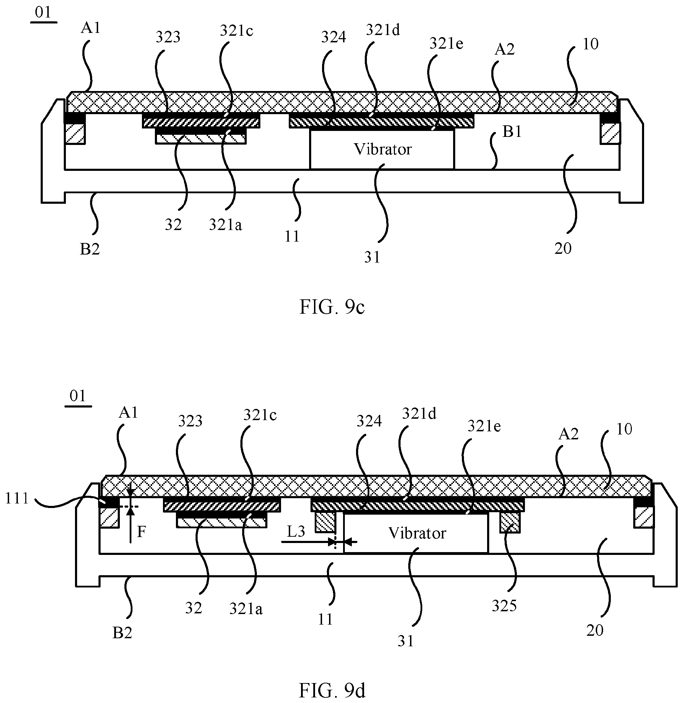

Alternatively, in another possible implementation solution of this example, the display module 10 further includes a first support sheet 323 shown in FIG. 9c. The first support sheet 323 is located between the vibrating sheet 32 and the display module 10. The first support sheet 323 is connected to the upper surface C1 of the vibrating sheet 32 by using the first glue layer 321a. In addition, the first support sheet 323 is connected to the lower surface A2 of the display module 10 by using a third glue layer 321c.

In addition, as shown in FIG. 9c, the display terminal 01 further includes a second support sheet 324. The second support sheet 324 is located between the vibrator 31 and the display module 10. The second support sheet 324 is connected to the lower surface A2 of the display module 10 by using a fourth glue layer 321d. In addition, the second support sheet 324 is further connected to the upper surface of the vibrator 31 by using a fifth glue layer 321e.

It should be noted that materials of the fourth glue layer 321d and the fifth glue layer 321e are the same as those described above. Details are not described herein. Vibration of the vibrator 31 may be coupled to the display module 10 by using the fourth glue layer 321d and the fifth glue layer 321e. The fourth glue layer 321d and the fifth glue layer 321e may be entire film layers respectively located on the second support sheet 324 and the upper surface of the vibrator 31.

In addition, an area of an upper surface (namely, a surface on which the second support sheet 324 is in contact with the display module 10) of the second support sheet 324 is greater than an area of the upper surface of the vibrator 31. In this case, one part of the second support sheet 324 is connected to the vibrator 31 by using the fifth glue layer 321e, and the other part extends out of the vibrator 31, and is located around the vibrator 31.

In this way, there is a relatively large contact area between the second support sheet 324 and the display module 10 because the second support sheet 324 is of a sheet-like structure. Therefore, by setting the upper surface and a lower surface of the second support sheet 324 to be respectively in contact with the display module 10 and the vibrator 31, a contact area between the vibrator 31 and the display module 10 may be increased, so that driving force provided by the vibrator 31 for the display module 10 in a vibration process can be more evenly applied to the display module 10, to reduce a probability that the display module 10 is damaged in the vibration process.

In addition, by using the second support sheet 324, an area of a deformation region of the display module 10 may be further increased, so that the driving force provided by the vibrator 31 for the display module 10 in the vibration process can be transferred to the display module 10 to a greater extent, to improve efficiency of driving, by the vibrator 31, the display module 10 to vibrate, reduce power consumption, and improve an effect for implementing sound on display.

It should be noted that the first support sheet 323 and the second support sheet 324 may be metal sheets. Materials of which the first support sheet 323 and the second support sheet 324 are made may be metal elemental materials or metal alloy materials.

On this basis, as shown in FIG. 9d, the display terminal 01 further includes at least one second mass block 325 disposed on the lower surface of the second support sheet 324. A region in which the vibrator 31 is vertically projected on the lower surface of the second support sheet 324 and a region in which the second mass block 325 is vertically projected on the lower surface of the second support sheet 324 do not overlap. In this case, the second mass block 325 is located around the vibrator 31, and there is a third gap L3 between the second mass block 325 and the vibrator 31.

It should be noted that a size of the third gap L3 is not limited in this application, provided that it can be ensured that a case in which vibration of the vibrator 31 is affected because in a vibration process of the vibrator 31, the second mass block 325 is in contact with the vibrator 31 is avoided.

In addition, a manner of disposing the at least one second mass block 325 on the lower surface of the second support sheet 324 and technical effects are the same as the manner of disposing the first mass block 322. Details are not described herein. A person skilled in the art may perform force analysis in a process of transferring the driving force from the vibrator 31 to the display module 10 by using the second support sheet 324, to obtain a disposing manner that is more favorable to drive the display module 10 to vibrate.

In this case, the second mass block 325 is disposed at a part that is of the second support sheet 324 and that extends out of the vibrator 31. Therefore, in the process of transferring the driving force from the vibrator 31 to the display module 10 by using the second support sheet 324, the second mass block 325 may generate a vibration acceleration, and the acceleration is coupled to the display module 10 by using the second support sheet 324, so that driving force coupled to the display module 10 by using the second support sheet 324 can be increased, to increase volume for implementing sound on display.

The second mass block 325 may be made of a metal material.

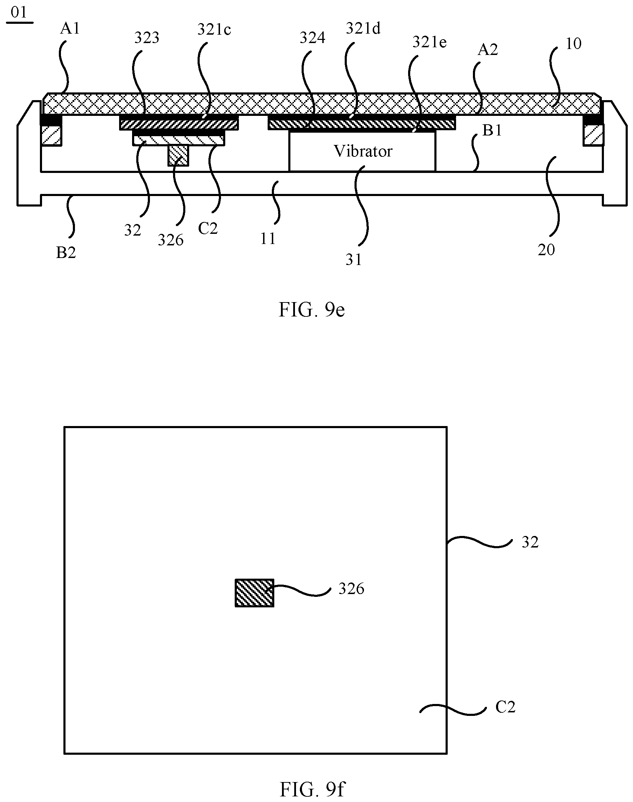

In addition, to increase the driving force coupled to the display module 10 by using the vibrating sheet 32, in some embodiments of this application, the display terminal 01 further includes at least one third mass block 326 that is shown in FIG. 9e and located on the lower surface C2 of the vibrating sheet 32.

A manner of disposing the third mass block 326 is the same as the manner of disposing the first mass block 322. The vibrating sheet 32 may include four third mass blocks 326. Each third mass block 326 is located in one corner of the lower surface C2. Alternatively, for another example, the vibrating sheet 32 may include a plurality of (for example, at least four) third mass blocks 326. The plurality of third mass blocks 326 are disposed around an edge of the lower surface C2. Alternatively, the vibrating sheet 32 may include one third mass block 326. The third mass block 326 is a head-to-tail connected frame structure.

Alternatively, as shown in FIG. 9f, the vibrating sheet 32 may include one third mass block 326. The third mass block 326 is located at a central position of the lower surface C2 of the vibrating sheet 32.

In some possible implementations of this application, the third mass block 326 may be made of a metal elemental material or a metal alloy material. In this case, as shown in FIG. 9e, the third mass block 326 is disposed on the lower surface C of the vibrating sheet 32. Therefore, in a deformation process of the vibrating sheet 32, the third mass block 326 may generate a vibration acceleration, and the acceleration is coupled to the display module 10 by using the vibrating sheet 32, so that driving force coupled to the display module 10 by using the vibrating sheet 32 can be increased, to increase the volume for implementing sound on display.

It should be noted that the manner of disposing the third mass block 326 on the lower surface C2 is merely described above by using an example. A person skilled in the art may perform force analysis based on assistance of the third mass block 326 and a deformation form and a deformation degree of the vibrating sheet 32 in a process of driving the display module 10 to vibrate, to obtain a disposing manner that is more favorable to drive the display module 10 to vibrate.

Other manners of disposing the third mass block 326 on the lower surface C2 are not described herein one by one, provided that it can be ensured that in the deformation process, the vibrating sheet 32 can drive the display module 10 to vibrate in the direction perpendicular to the lower surface A2 of the display module 10.

It may be learned from the foregoing description that for the solution in the example 3, as shown in FIG. 9a, the vibrating sheet 32 is located around the vibrator 31. The vibrator 31 (or the vibrating sheet 32) may be disposed at a central position of the accommodation space 20 (shown in FIG. 4a), to be connected to a central position of the display module 10. The vibrating sheet 32 (or the vibrator 31) is disposed at an edge position of the accommodation space 20, and the part may serve as a receiver of a mobile phone.

In this way, driving force provided when the vibrator 31 (or the vibrating sheet 32) connected to the central position of the display module 10 vibrates may directly act on the central position of the display module 10 that serves as the diaphragm, to increase amplitude of the entire display module 10. Therefore, in a process of implementing sound on display by using the display module 10 that serves as a speaker, both a low-frequency sound signal and a high-frequency sound signal can be transmitted at relatively high volume.

In addition, when the vibrating sheet 32 (or the vibrator 31) close to the edge position of the accommodation space 20 vibrates, amplitude of the display module 10 at the edge position may be increased. Therefore, in a process of implementing sound on display by using the display module 10 that serves as a receiver, a high-frequency sound signal can be transmitted at relatively high volume.

In any one of the foregoing embodiments and examples, it may be learned from the foregoing description that an adhesive layer 111 shown in FIG. 9d is disposed between the display module 10 and the middle frame 11. In a possible implementation of this application, a thickness F of the adhesive layer 111 may range from 0.2 mm to 0.5 mm, and a Young's modulus of the adhesive layer 111 may range from 10 Mpa to 80 Mpa.

When the thickness F of the adhesive layer 111 is less than 0.2 mm, the adhesive layer 111 has excessively low adhesive strength. This is unfavorable to firmly bond the display module 10 and the middle frame 11.

When the thickness F of the adhesive layer 111 ranges from 0.2 mm to 0.5 mm, the adhesive layer 111 can firmly bond the display module 10 and the middle frame 11. In addition, in the thickness range, a larger thickness F of the adhesive layer 111 indicates a softer texture of the adhesive layer 111 and a higher probability that the display module 10 vibrates after force is applied. This is favorable to increase the volume for implementing sound on display.

For example, the thickness F of the adhesive layer 111 may be 0.2 mm, 0.3 mm, 0.4 mm, or 0.5 mm.

When the thickness F of the adhesive layer 111 is greater than 0.5 mm, the adhesive layer 111 has an excessively soft texture. Therefore, in a vibration process of the display module 10, a boundary condition of the display terminal 01 is softer, and reliability of the entire display terminal 01 is reduced, and consequently a display 101 is prone to a risk of being broken.

In addition, when the Young's modulus of the adhesive layer 111 may range from 10 Mpa to 80 Mpa, a smaller Young's modulus of the adhesive layer 111 indicates a softer boundary condition of the display terminal 01 and a higher probability that the display module 10 vibrates. In this way, the volume for implementing sound on display can be effectively increased.

It may be learned from the foregoing description that in the display terminal 01, after receiving the driving signal output by the audio digital processor 300, each of the vibrator 31 and the vibrating sheet 32 may drive, in the direction perpendicular to the lower surface A2 of the display module 10, the display module 10 to vibrate, to implement sound on display. An implementation of how the vibrator 31 and the vibrating sheet 32 receive the driving signal output by the audio digital processor 300 is described below by using an example.

### Example 4

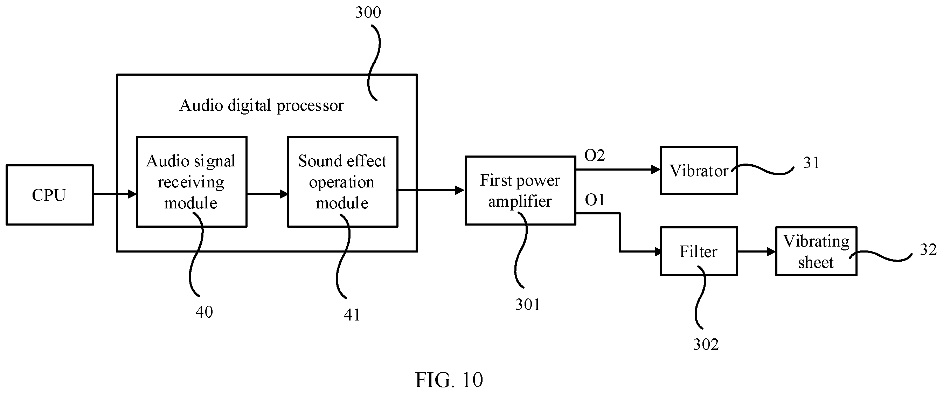

In this example, the display terminal 01 includes an audio digital processor 300, a first power amplifier 301, and a filter 302 shown in FIG. 10.

An output end of the audio digital processor 300 is coupled to an input end of the first power amplifier 301. The audio digital processor 300 is configured to output an audio signal to the first power amplifier 301.

In some embodiments of this application, the audio digital processor 300 includes an audio signal receiving module 40 and a sound effect operation module 41. The audio signal receiving module 40 may be electrically connected to the CPU that is disposed on the PCB and shown in FIG. 1, to receive an audio signal output by the CPU.

In addition, the sound effect operation module 41 is configured to adjust a frequency band of the audio signal output by the audio signal receiving module 40, to adjust an audio effect.

For example, when a low frequency of the audio signal output by the audio signal receiving module 40 is insufficient, the sound effect operation module 41 may increase a frequency of a low-frequency part output by the audio signal receiving module 40. Alternatively, when a high frequency of the audio signal output by the audio signal receiving module 40 is relatively high, the sound effect operation module 41 may reduce a frequency of a high-frequency part output by the audio signal receiving module 40. Therefore, audio output by the audio digital processor 300 can meet a requirement of an audio signal to be processed by the first power amplifier 301.

It should be noted that the audio signal output by the CPU may be an audio signal generated when the display terminal 01 plays a sound, for example, music or a video. Alternatively, the audio signal may be a sound transmitted to the CPU by using a receiver when the display terminal 01 is on a voice call. A frequency of an audio signal that can be received by a human ear usually ranges from 200 Hz to 20 kHz. Therefore, a frequency of the audio signal output by the CPU may range from 200 Hz to 20 kHz.

On this basis, a first output end O1 of the first power amplifier 301 is coupled to the filter 302. A second output end O2 of the first power amplifier 301 is coupled to the vibrator 31. The first power amplifier 301 is configured to perform power amplification processing on the audio signal processed by the sound effect operation module 41, so that the vibrator 31 can be driven to vibrate after receiving the audio signal (at hundreds of kHz, for example, 400 kHz) output by the first power amplifier 301, and a vibration phase of the vibrator 31 is a first phase. In some embodiments of this application, the first power amplifier 301 may be a smart (smart) power amplifier (power amplifier, PA) that is of a class H type and that is with a relatively high output frequency.

It may be learned from the foregoing description that when the vibrator 31 includes the first magnetic object 311 and the second magnetic object 312, the first magnetic object 311 or the second magnetic object 312 may be a coil. In this case, after the vibrator 31 receives the audio signal that is at 400 kHz and output by the first power amplifier 301, the coil may serve an inductor, filter out a part of the audio, and drive, under action of the filtered audio signal, the display module 10 to emit a sound at a frequency that ranges from 200 Hz to 20 kHz.

In addition, it may be learned from the foregoing description that the vibrating sheet 32 mainly includes the vibrating sheet 32, and the vibrating sheet 32 may be equivalent to a capacitor. Therefore, when the first power amplifier 301 that can output an audio signal at hundreds of kHz is directly coupled to the vibrating sheet 32, the vibrating sheet 32 is short-circuited. Therefore, the filter 302 needs to be coupled between the first power amplifier 301 and the vibrating sheet 32.

The filter 302 is configured to filter the audio signal processed by the sound effect operation module 41. For example, a part of the audio signal that is at 400 kHz and output by the first power amplifier 301 is filtered out, so that the vibrating sheet 32 vibrates in the first phase under control of the filtered audio signal, and drives the display module 10 to emit a sound at a frequency that ranges from 200 Hz to 20 kHz.

For ease of description, in the range from 200 Hz to 20 kHz, an audio signal at 200 Hz to 4 kHz may be referred to as a low-frequency signal, and a signal at 4 kHz to 20 kHz may be referred to as an intermediate-frequency signal or a high-frequency signal. In this application, division into the low-frequency signal, the intermediate-frequency signal, and the high-frequency signal is merely an example for description, and is not intended to limit the low-frequency signal, the intermediate-frequency signal, and the high-frequency signal.

On this basis, a process in which the vibrator 31 and the vibrating sheet 32 drive, based on the frequency of the audio signal output by the CPU, the display module 10 to implement sound on display is described below.

For example, when the CPU in FIG. 10 outputs a low-frequency signal at 1 kHz, after the low-frequency signal passes through the audio digital processor 300 and the first power amplifier 301, an audio signal that is at hundreds of kHz and output by the first power amplifier 301 is applied to the vibrator 31, to drive the vibrator 31 to vibrate. The vibrator 31 that serves as an inductor filters out a part of the audio signal at hundreds of kHz, and vibrates under action of the remaining audio signal at 1 kHz.

In addition, after the audio signal that is at hundreds of kHz and output by the first power amplifier 301 passes through the filter 302, a part of the audio signal at hundreds of kHz is filtered out, and the remaining audio signal at 1 kHz is applied to the vibrating sheet 32.

The vibrator 31 and the vibrating sheet 32 are connected in parallel, and therefore a same voltage is applied to the vibrator 31 and the vibrating sheet 32. On this basis, under driving of the low-frequency signal at 1 kHz, there is relatively small impedance (for example, 8 ohms) for a coil in the vibrator 31, and therefore a relatively strong current flows through the coil. There is relatively large impedance (for example, 200 ohms) for the vibrating sheet 32 that serves as a capacitor, and therefore a relatively weak current flows through the vibrating sheet 32. In this case, when the vibrator 31 and the vibrating sheet 32 simultaneously vibrate, vibration of the vibrator 31 and the vibrating sheet 32 may be superimposed because the vibration phases are the same, and the vibrator 31 serves as a main driving source to drive the display module 10 to vibrate, to emit a low-frequency signal at 1 kHz.

Alternatively, when the CPU in FIG. 10 outputs a high-frequency signal at 10 kHz, after the high-frequency signal passes through the audio digital processor 300 and the first power amplifier 301, an audio signal that is at hundreds of kHz and output by the first power amplifier 301 is applied to the vibrator 31, to drive the vibrator 31 to vibrate. The vibrator 31 that serves as an inductor filters out a part of the audio signal at hundreds of kHz, and vibrates under action of the remaining audio signal at 10 kHz.

In addition, after the audio signal that is at hundreds of kHz and output by the first power amplifier 301 passes through the filter 302, a part of the audio signal at hundreds of kHz is filtered out, and the remaining audio signal at 10 kHz is applied to the vibrating sheet 32.

The vibrator 31 and the vibrating sheet 32 are connected in parallel, and therefore a same voltage is applied to the vibrator 31 and the vibrating sheet 32. On this basis, under driving of the high-frequency signal at 10 kHz, there is relatively large impedance (for example, 40 ohms) for a coil in the vibrator 31, and therefore a relatively weak current flows through the coil. There is relatively small impedance (for example, 2 ohms) for the vibrating sheet 32 that serves as a capacitor, and therefore a relatively strong current flows through the vibrating sheet 32. In this case, when the vibrator 31 and the vibrating sheet 32 simultaneously vibrate, vibration of the vibrator 31 and the vibrating sheet 32 may be superimposed, and the vibrating sheet 32 may serve as a main driving source to drive the display module 10 to vibrate, to emit a high-frequency signal at 10 kHz, so as to resolve a problem that a high-frequency signal is emitted on the display at relatively low volume.

### Example 5

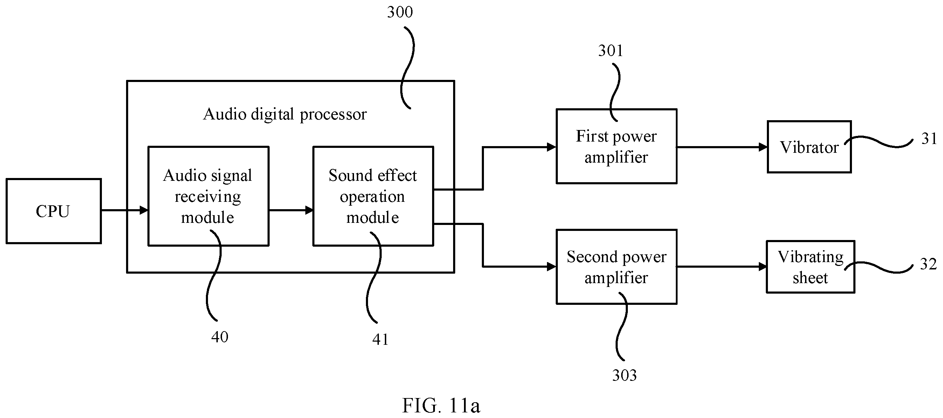

In this example, the display terminal 01 includes an audio digital processor 300, a first power amplifier 301, and a second power amplifier 303 shown in FIG. 11a. An output frequency of the first power amplifier 301 is greater than an output frequency of the second power amplifier 303.

For example, the first power amplifier 301 may be the foregoing smart PA of the class H type, and the second power amplifier 303 may be a smart PA of an AB type.

An output end of the audio digital processor 300 is coupled to an input end of the first power amplifier 301 and the second power amplifier 301. The audio digital processor 300 is configured to output an audio signal to the first power amplifier 301 and the second power amplifier 303.

A structure of the audio digital processor 300 is the same as that in the example 4. Details are not described herein.

In addition, an output end of the first power amplifier 301 is coupled to the vibrator 31. The first power amplifier 301 is configured to amplify the audio signal output by the audio digital processor 300, to drive the vibrator 31 to vibrate.

An output end of the second power amplifier 303 is coupled to the vibrating sheet 32, and the second power amplifier 303 is configured to amplify the audio signal output by the audio digital processor 300, so that a vibration phase of the vibrating sheet 32 is a first phase.

The second power amplifier 303 has a relatively low output frequency, and therefore when the vibrating sheet 32 includes the vibrating sheet 32, a signal output by the second power amplifier 303 can drive the vibrating sheet 32 to vibrate, and the vibrating sheet 32 can be prevented from being short-circuited.

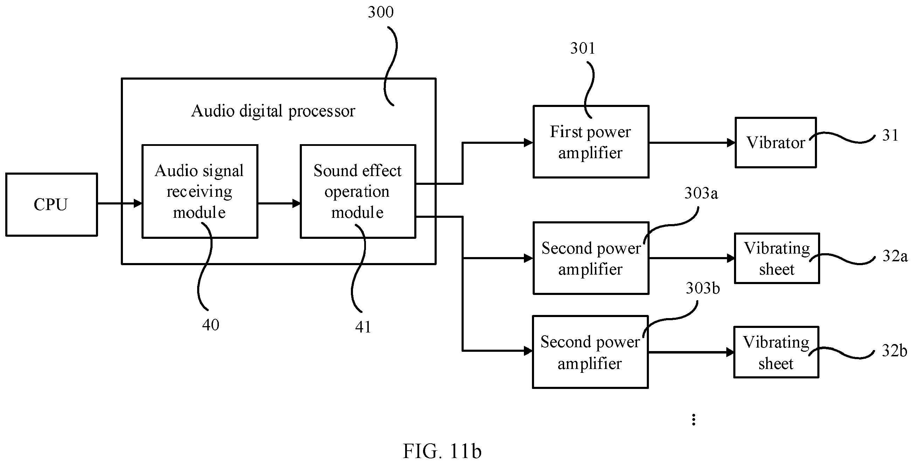

In addition, it may be learned from the foregoing description that the display terminal 01 may include a plurality of vibrating sheets, for example, a vibrating sheet 32a and a vibrating sheet 32b shown in FIG. 11b. On this basis, in some embodiments of this application, as shown in FIG. 11b, the display terminal 01 may include a plurality of second power amplifiers, for example, a second power amplifier 303a and a second power amplifier 303b. Each second power amplifier 303 is coupled to one vibrating sheet 32.

In this way, each vibrating sheet 32 may be independently controlled by using one second power amplifier 303. When relatively high volume is required for implementing sound on display, it may be set that each second power amplifier 303 drives a vibrating sheet 32 coupled to the second power amplifier 303 to vibrate. In this case, all the vibrating sheets 32 provide driving force for the display module 10, so that a vibration frequency of the display module 10 can be increased, to increase the volume for implementing sound on display. Alternatively, when relatively low volume is required for implementing sound on display, it may be set that some second power amplifiers 303 drive vibrating sheets 32 coupled to the second power amplifiers 303 to vibrate. In this case, only the some vibrating sheets 32 provide driving force for the display module 10, and therefore there is no excessively high volume for implementing sound on display.

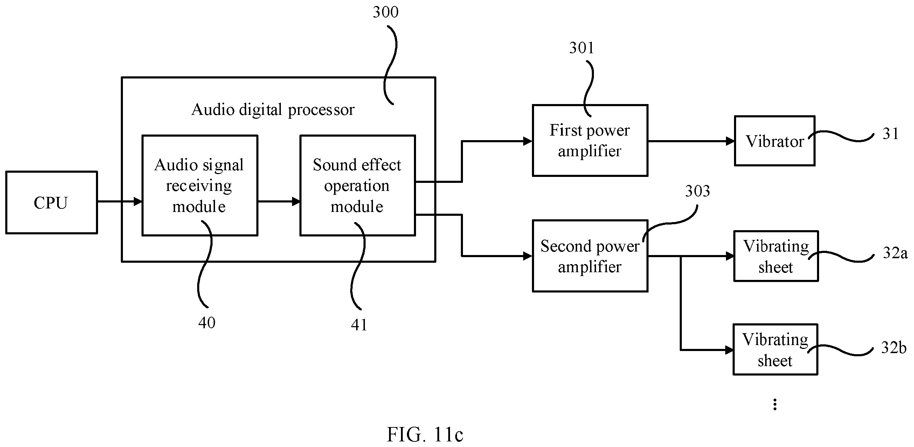

Alternatively, in some other embodiments of this application, as shown in FIG. 11c, the display terminal 01 may include one second power amplifier 303 and a plurality of vibrating sheets, for example, a vibrating sheet 32a and a vibrating sheet 32b, coupled to the second power amplifier 303. In this way, the plurality of vibrating sheets may be simultaneously controlled, by using the one second power amplifier 303, to vibrate. Therefore, a circuit structure of the display terminal 01 can be simplified.

It should be noted that letters "a" and "b" after an identifier "32" of the vibrating sheet are merely used to distinguish between different vibrating sheets, and the letters constitute no limitation on a structure of the vibrating sheet. In addition, letters "a" and "b" after an identifier "303" of the second power amplifier are merely used to distinguish between different second power amplifiers, and the letters constitute no limitation on a structure of the second power amplifier.

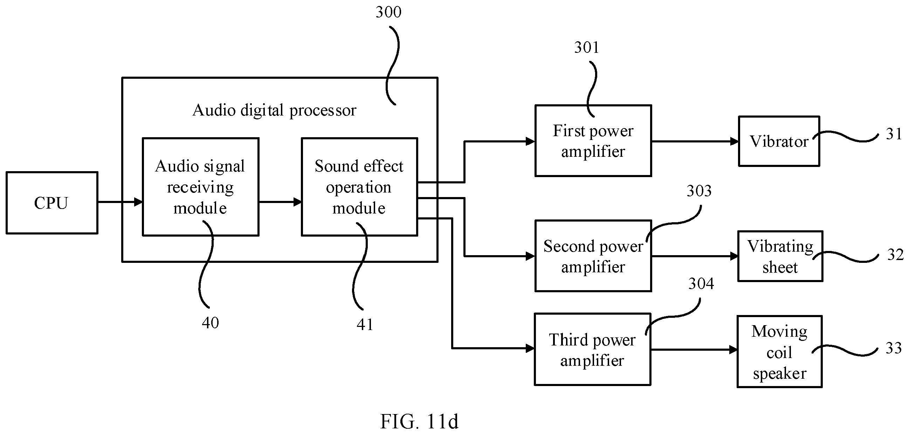

In addition, when the display terminal 01 further includes a moving coil speaker 33 shown in FIG. 11d, the display terminal 01 may include a third power amplifier 304 coupled to the audio digital processor 300 and the moving coil speaker 33. The third power amplifier 304 may be the foregoing smart PA of the class H type.

In this way, after the audio digital processor 300 outputs the audio signal, under respective control of the first power amplifier 301 and the second power amplifier 303, the vibrator 31 and the vibrating sheet 32 jointly drive the display module 10 to vibrate, to implement sound on display. The third power amplifier 304 controls the moving coil speaker to emit a sound signal, so that the display terminal 01 can implement multi-channel sound.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A display terminal (01), comprising:
a middle frame (11);
a display module (10), connected to the middle frame (11), wherein accommodation space (20) is formed between the display module (10) and the middle frame (11);
a vibrator (31), wherein at least a part of the vibrator (31) is disposed in the accommodation space (20), and the vibrator (31) is connected to the display module (10) or the middle frame (11); and
at least one vibrating sheet (32), located in the accommodation space (20), wherein an upper surface of the vibrating sheet (32) is connected to a lower surface of the display module (10), and a lower surface of the vibrating sheet (32) faces the middle frame (11); and
in a direction perpendicular to the upper surface of the vibrating sheet (32), the vibrator (31) and the vibrating sheet (32) are configured to drive the display module (10) to vibrate up and down; and
at least one first mass block (322),
**characterized in that** the vibrating sheet (32) is located between the vibrator (31) and the display module (10), the lower surface of the vibrating sheet (32) is connected to an upper surface of the vibrator (31), and a lower surface of the vibrator (31) is connected to the middle frame (11),
wherein the area of the upper surface of the vibrating sheet (32) is greater than an area of the upper surface of the vibrator (31),
wherein the at least one first mass block (322) is disposed on the lower surface of the vibrating sheet (32); and
a region in which the vibrator (31) is vertically projected on the lower surface of the vibrating sheet (32) and a region in which the first mass block (322) is vertically projected on the lower surface of the vibrating sheet (32) do not overlap.

2. The display terminal according to claim 1, wherein the display terminal (01) further comprises a first support sheet (323);
the first support sheet (323) is located between the vibrating sheet (32) and the display module (10), an upper surface of the first support sheet (323) is connected to the lower surface of the display module (10), and a lower surface of the first support sheet (323) is connected to the upper surface of the vibrating sheet (32); and
an area of the upper surface of the first support sheet (323) is greater than an area of the upper surface of the vibrating sheet (32).

3. The display terminal according to claim 1, wherein the display terminal further comprises a first glue layer (321a) located on the upper surface of the vibrating sheet; and
the first glue layer (321a) is disposed along an edge of the upper surface of the vibrating sheet.

4. The display terminal according to claim 1, wherein a thickness of the vibrating sheet ranges from 0.2 mm to 2 mm.

5. The display terminal according to claim 1, wherein an adhesive layer (111) is disposed between the display module and the middle frame, a thickness of the adhesive layer (111) ranges from 0.2 mm to 0.5 mm, and a Young's modulus of the adhesive layer (111) ranges from 10 Mpa to 80 Mpa.

6. The display terminal according to claim 1, wherein the vibrator comprises a first magnetic object (311) and a second magnetic object (312), the first magnetic object (311) is connected to the display module, and the second magnetic object (312) is connected to the middle frame.

7. The display terminal according to claim 1, wherein the display terminal comprises an audio digital processor (300), a first power amplifier (301), and a filter (302);
an output end of the audio digital processor (300) is coupled to an input end of the first power amplifier (301), and the audio digital processor (300) is configured to output an audio signal to the first power amplifier (301);
a first output end of the first power amplifier (301) is coupled to the filter (302), a second output end of the first power amplifier (301) is coupled to the vibrator, and the first power amplifier (301) is configured to amplify the audio signal, so that a vibration phase of the vibrator is a first phase; and
an output end of the filter (302) is connected to the vibrating sheet, and the filter (302) is configured to filter the audio signal, so that a vibration phase of the vibrating sheet is the first phase.

8. The display terminal according to claim 1, wherein the display terminal comprises an audio digital processor (300), a first power amplifier (301), and a second power amplifier (303), and an output frequency of the first power amplifier (301) is greater than an output frequency of the second power amplifier (303);
an output end of the audio digital processor (300) is coupled to an input end of the first power amplifier (301) and the second power amplifier (303), and the audio digital processor (300) is configured to output an audio signal to the first power amplifier (301) and the second power amplifier (303);
an output end of the first power amplifier (301) is coupled to the vibrator, and the first power amplifier (301) is configured to amplify the audio signal, so that a vibration phase of the vibrator is a first phase; and
an output end of the second power amplifier (303) is coupled to the vibrating sheet, and the second power amplifier (303) is configured to amplify the audio signal, so that a vibration phase of the vibrating sheet is the first phase.

## Patentansprüche

1. Anzeigeendgerät (01), umfassend:
einen mittleren Rahmen (11);
ein Anzeigemodul (10), das mit dem mittleren Rahmen (11) verbunden ist, wobei Unterbringungsraum (20) zwischen dem Anzeigemodul (10) und dem mittleren Rahmen (11) gebildet wird;
einen Vibrator (31), wobei mindestens ein Teil des Vibrators (31) in dem Unterbringungsraum (20) angeordnet ist und der Vibrator (31) mit dem Anzeigemodul (10) oder dem mittleren Rahmen (11) verbunden ist; und
mindestens ein vibrierendes Blatt (32), das sich in dem Unterbringungsraum (20) befindet, wobei eine obere Oberfläche des vibrierenden Blatts (32) mit einer unteren Oberfläche des Anzeigemoduls (10) verbunden ist und eine untere Oberfläche des vibrierenden Blatts (32) zu dem mittleren Rahmen (11) weist; und
in einer Richtung senkrecht zu der oberen Oberfläche des vibrierenden Blatts (32) der Vibrator (31) und das vibrierende Blatt (32) konfiguriert sind zum Antreiben des Anzeigemoduls (10), nach oben und nach unten zu vibrieren; und mindestens einen ersten Massenblock (322),
**dadurch gekennzeichnet, dass** das vibrierende Blatt (32) sich zwischen dem Vibrator (31) und dem Anzeigemodul (10) befindet, die untere Oberfläche des vibrierenden Blatts (32) mit einer oberen Oberfläche des Vibrators (31) verbunden ist und eine untere Oberfläche des Vibrators (31) mit dem mittleren Rahmen (11) verbunden ist,
wobei die Fläche der oberen Oberfläche des vibrierenden Blatts (32) größer als eine Fläche der oberen Oberfläche des Vibrators (31) ist,
wobei der mindestens eine erste Massenblock (322) auf der unteren Oberfläche des vibrierenden Blatts (32) angeordnet ist; und
eine Region, in dem der Vibrator (31) vertikal auf die untere Oberfläche des vibrierenden Blatts (32) projiziert wird, und eine Region, in der der erste Massenblock (322) vertikal auf die untere Oberfläche des vibrierenden Blatts (32) projiziert wird, nicht überlappen.

2. Anzeigeendgerät nach Anspruch 1, wobei das Anzeigeendgerät (01) ferner ein erstes Trägerblatt (323) umfasst;
das erste Trägerblatt (323) sich zwischen dem vibrierenden Blatt (32) und dem Anzeigemodul (10) befindet, eine obere Oberfläche des ersten Trägerblatts (323) mit der unteren Oberfläche des Anzeigemoduls (10) verbunden ist und eine untere Oberfläche des ersten Trägerblatts (323) mit der oberen Oberfläche des vibrierenden Blatts (32) verbunden ist; und
eine Fläche der oberen Oberfläche des ersten Trägerblatts (323) größer als eine Fläche der oberen Oberfläche des vibrierenden Blatts (32) ist.

3. Anzeigeendgerät nach Anspruch 1, wobei das Anzeigeendgerät ferner eine erste Kleberschicht (321a) umfasst, die sich auf der oberen Oberfläche des vibrierenden Blatts befindet; und
die erste Kleberschicht (321a) entlang einer Kante der oberen Oberfläche des vibrierenden Blatts angeordnet ist.

4. Anzeigeendgerät nach Anspruch 1, wobei eine Dicke des vibrierenden Blatts von 0,2 mm bis 2 mm reicht.

5. Anzeigeendgerät nach Anspruch 1, wobei eine Haftschicht (111) zwischen dem Anzeigemodul und dem mittleren Rahmen angeordnet ist, eine Dicke der Haftschicht (111) von 0,2 mm bis 0,5 mm reicht und ein Elastizitätsmodul der Haftschicht (111) von 10 Mpa bis 80 Mpa reicht.

6. Anzeigeendgerät nach Anspruch 1, wobei der Vibrator ein erstes magnetisches Objekt (311) und ein zweites magnetisches Objekt (312) umfasst, das erste magnetische Objekt (311) mit dem Anzeigemodul verbunden ist und das zweite magnetische Objekt (312) mit dem mittleren Rahmen verbunden ist.

7. Anzeigeendgerät nach Anspruch 1, wobei das Anzeigeendgerät einen digitalen Audioprozessor (300), einen ersten Leistungsverstärker (301) und ein Filter (302) umfasst;
ein Ausgangsende des digitalen Audioprozessors (300) an ein Eingangsende des ersten Leistungsverstärkers (301) gekoppelt ist und der digitale Audioprozessor (300) konfiguriert ist zum Ausgeben eines Audiosignals an den ersten Leistungsverstärker (301);
ein erstes Ausgangsende des ersten Leistungsverstärkers (301) an das Filter (302) gekoppelt ist, ein zweites Ausgangsende des ersten Leistungsverstärkers (301) an den Vibrator gekoppelt ist und der erste Leistungsverstärker (301) konfiguriert ist zum Verstärken des Audiosignals, so dass eine Vibrationsphase des Vibrators eine erste Phase ist; und
ein Ausgangsende des Filters (302) mit dem vibrierenden Blatt verbunden ist und das Filter (302) konfiguriert ist zum Filtern des Audiosignals, so dass eine Vibrationsphase des vibrierenden Blatts die erste Phase ist.

8. Anzeigeendgerät nach Anspruch 1, wobei das Anzeigeendgerät einen digitalen Audioprozessor (300), einen ersten Leistungsverstärker (301) und einen zweiten Leistungsverstärker (303) umfasst und eine Ausgangsfrequenz des ersten Leistungsverstärkers (301) größer als eine Ausgangsfrequenz des zweiten Leistungsverstärkers (303) ist;
ein Ausgangsende des digitalen Audioprozessors (300) an ein Eingangsende des ersten Leistungsverstärkers (301) und des zweiten Leistungsverstärkers (303) gekoppelt ist und der digitale Audioprozessor (300) konfiguriert ist zum Ausgeben eines Audiosignals an den ersten Leistungsverstärker (301) und den zweiten Leistungsverstärker (303);
ein Ausgangsende des ersten Leistungsverstärkers (301) an den Vibrator gekoppelt ist und der erste Leistungsverstärker (301) konfiguriert ist zum Verstärken des Audiosignals, so dass eine Vibrationsphase des Vibrators eine erste Phase ist; und
ein Ausgangsende des zweiten Leistungsverstärkers (303) an das vibrierende Blatt gekoppelt ist und der zweite Leistungsverstärker (303) konfiguriert ist zum Verstärken des Audiosignals, so dass eine Vibrationsphase des vibrierenden Blatts die erste Phase ist.

## Revendications

1. Terminal d'affichage (01), comprenant :
un cadre intermédiaire (11) ;
un module d'affichage (10), connecté au cadre intermédiaire (11), un espace de logement (20) étant formé entre le module d'affichage (10) et le cadre intermédiaire (11) ;
un vibrateur (31), au moins une partie du vibrateur (31) étant disposée dans l'espace de logement (20), et le vibrateur (31) étant connecté au module d'affichage (10) ou au cadre intermédiaire (11) ; et
au moins une plaque vibrante (32), située dans l'espace de logement (20), une surface supérieure de la plaque vibrante (32) étant connectée à une surface inférieure du module d'affichage (10), et une surface inférieure de la plaque vibrante (32) faisant face au cadre intermédiaire (11) ; et
dans une direction perpendiculaire à la surface supérieure de la plaque vibrante (32), le vibrateur (31) et la plaque vibrante (32) étant configurés pour entraîner le module d'affichage (10) à vibrer de haut en bas ; et
au moins un premier bloc de masse (322),
**caractérisé en ce que** la plaque vibrante (32) est située entre le vibrateur (31) et le module d'affichage (10), la surface inférieure de la plaque vibrante (32) étant connectée à une surface supérieure du vibrateur (31), et une surface inférieure du vibrateur (31) étant connectée au cadre intermédiaire (11),
la superficie de la surface supérieure de la plaque vibrante (32) étant plus grande qu'une superficie de la surface supérieure du vibrateur (31),
l'au moins un premier bloc de masse (322) étant disposé sur la surface inférieure de la plaque vibrante (32) ; et
une région dans laquelle le vibrateur (31) est projeté verticalement sur la surface inférieure de la plaque vibrante (32) et une région dans laquelle le premier bloc de masse (322) est projeté verticalement sur la surface inférieure de la plaque vibrante (32) ne se chevauchant pas.

2. Terminal d'affichage selon la revendication 1, le terminal d'affichage (01) comprenant en outre une première plaque de support (323) ;
la première plaque de support (323) étant située entre la plaque vibrante (32) et le module d'affichage (10), une surface supérieure de la première plaque de support (323) étant connectée à la surface inférieure du module d'affichage (10), et une surface inférieure de la première plaque de support (323) étant connectée à la surface supérieure de la plaque vibrante (32) ; et
une superficie de la surface supérieure de la première plaque de support (323) étant plus grande qu'une superficie de la surface supérieure de la plaque vibrante (32).

3. Terminal d'affichage selon la revendication 1, le terminal d'affichage comprenant en outre une première couche de colle (321a) située sur la surface supérieure de la plaque vibrante ; et
la première couche de colle (321a) étant disposée le long d'un bord de la surface supérieure de la plaque vibrante.

4. Terminal d'affichage selon la revendication 1, une épaisseur de la plaque vibrante s'étendant de 0,2 mm à 2 mm.

5. Terminal d'affichage selon la revendication 1, une couche adhésive (111) étant disposée entre le module d'affichage et le cadre intermédiaire, une épaisseur de la couche adhésive (111) s'étendant de 0,2 mm à 0,5 mm, et un module de Young de la couche adhésive (111) s'étendant de 10 MPa à 80 MPa.

6. Terminal d'affichage selon la revendication 1, le vibrateur comprenant un premier objet magnétique (311) et un second objet magnétique (312), le premier objet magnétique (311) étant connecté au module d'affichage, et le second objet magnétique (312) étant connecté au cadre intermédiaire.

7. Terminal d'affichage selon la revendication 1, le terminal d'affichage comprenant un processeur numérique audio (300), un premier amplificateur de puissance (301), et un filtre (302) ;
une extrémité de sortie du processeur numérique audio (300) étant couplée à une extrémité d'entrée du premier amplificateur de puissance (301), et le processeur numérique audio (300) étant configuré pour délivrer un signal audio au premier amplificateur de puissance (301) ;
une première extrémité de sortie du premier amplificateur de puissance (301) étant couplée au filtre (302), une seconde extrémité de sortie du premier amplificateur de puissance (301) étant couplée au vibrateur, et le premier amplificateur de puissance (301) étant configuré pour amplifier le signal audio, de sorte qu'une phase de vibration du vibrateur est une première phase ; et
une extrémité de sortie du filtre (302) étant connectée à la plaque vibrante, et le filtre (302) étant configuré pour filtrer le signal audio, de sorte qu'une phase de vibration de la plaque vibrante est la première phase.

8. Terminal d'affichage selon la revendication 1, le terminal d'affichage comprenant un processeur numérique audio (300), un premier amplificateur de puissance (301), et un second amplificateur de puissance (303), et une fréquence de sortie du premier amplificateur de puissance (301) étant plus grande qu'une fréquence de sortie du second amplificateur de puissance (303) ;
une extrémité de sortie du processeur numérique audio (300) étant couplée à une extrémité d'entrée du premier amplificateur de puissance (301) et du second amplificateur de puissance (303), et le processeur numérique audio (300) étant configuré pour délivrer un signal audio au premier amplificateur de puissance (301) et au second amplificateur de puissance (303) ;
une extrémité de sortie du premier amplificateur de puissance (301) étant couplée au vibrateur, et le premier amplificateur de puissance (301) étant configuré pour amplifier le signal audio, de sorte qu'une phase de vibration du vibrateur est une première phase ; et
une extrémité de sortie du second amplificateur de puissance (303) étant couplée à la plaque vibrante, et le second amplificateur de puissance (303) étant configuré pour amplifier le signal audio, de sorte qu'une phase de vibration de la plaque vibrante est la première phase.
